# EUROPEAN PATENT SPECIFICATION

(11) **EP 2 683 019 B1**
(45) Date of publication and mention of the grant of the patent: **19.08.2015**
(21) Application number: 12751907.2
(22) Date of filing: 27.02.2012
(51) Int. Cl.: H01M 14/00, H01L 31/04, H01G 9/20

(54) **DYE-SENSITIZED SOLAR CELL FOR LOW LIGHT INTENSITIES**
FARBSTOFFSENSIBILISIERTE SOLARZELLE FÜR NIEDRIGE LICHTINTENSITÄT
PHOTOPILE À COLORANT POUR FAIBLES INTENSITÉS LUMINEUSES

(30) Priority: 02.03.2011 JP 2011044732
(43) Date of publication of application: 08.01.2014
(73) Proprietor: Fujikura Ltd., Tokyo 135-8512 (JP)
(72) Inventor: SHIMOHIRA Kouki, Sakura-shi Chiba 285-8550 (JP); OKADA Kenichi, Sakura-shi Chiba 285-8550 (JP); ENDO Katsuyoshi, Sakura-shi Chiba 285-8550 (JP)
(74) Representative: Hoffmann Eitle
(86) International application number: PCT/JP2012/054845
(87) International publication number: WO 2012/118044

(56) References cited:
- EP-A1- 1 473 745
- EP-A1- 2 230 702
- JP-A- 2004 127 579
- JP-A- 2006 278 112
- JP-A- 2007 141 473
- JP-A- 2010 040 432

## Description

### TECHNICAL FIELD

The present invention relates to a dye-sensitized solar cell for low illumination.

### BACKGROUND ART

As photoelectric conversion elements, attention has been paid to dye-sensitized solar cells since high photoelectric conversion efficiency can be obtained at low cost, and various developments have been made on dye-sensitized solar cells.

A dye-sensitized solar cell includes a working electrode, a counter electrode, a sealing section that connects the working electrode and the counter electrode, and an electrolyte that is filled in a cell space surrounded by the working electrode, the counter electrode, and the sealing section. Furthermore, the working electrode has a transparent substrate, a transparent conductive film provided thereon, and an oxide semiconductor layer which is a power generating layer provided on the transparent conductive film.

In recent years, dye-sensitized solar cells have been used not only as solar cells for outdoor use, but also as power supplies for various electronic equipment for indoor use.

However, generally, it is known that in an environment at low illumination (10,000 Lux or less) such as indoors, the generated current and the generated voltage of dye-sensitized solar cells are lowered. This is because since the amount of incident light decreases, the short circuit current decreases, and the open circuit voltage decreases because of the leakage current occurring between the oxide semiconductor layer as a current generating layer and the transparent conductive layer on the transparent substrate, and the electrolyte. Since the photoelectric conversion efficiency is directly proportional to the short circuit current and the open circuit voltage, when the short circuit current or the open circuit voltage decreases, the photoelectric conversion efficiency also decreases. Therefore, there is a demand for a dye-sensitized solar cell which is capable of increasing the short circuit current or the open circuit voltage even in an environment of low illumination such as indoors.

For example, in Patent Document 1 described below, it has been suggested to increase the short circuit current by reducing the absorption of incident light by the electrolyte by lowering the concentration of I₃⁻ in the electrolyte, and thereby increasing the light transmissibility.

### CITATION LIST

### PATENT DOCUMENT

Patent Document 1: JP 2005-251736 A

### SUMMARY OF INVENTION

### PROBLEM TO BE SOLVED BY THE INVENTION

However, the dye-sensitized solar cell described in the Patent Document 1 cannot be said to have sufficient photoelectric conversion characteristics in an environment of low illumination.

JP 2006 278112 A describes dye sensitized solar cells comprising a ruthenium dye and a deoxycholic acid co-adsorbent.

EP 2 230 702 A1 also discloses dye sensitized solar cells comprising a ruthenium dye and a co-adsorbent.

Similarly, EP 1 473 745 A1 and JP 2010 040432 A describe dye sensitized solar cells comprising ruthenium dyes and a co-adsorbent.

The present invention was achieved in view of such circumstances, and it is an object of the invention to provide a dye-sensitized solar cell for low illumination having excellent photoelectric conversion characteristics in an environment of low illumination at 10,000 Lux or less.

### MEANS FOR SOLVING PROBLEM

The inventors of the present invention conducted a thorough study in order to solve the problems described above, and as a result, the inventors contemplated that it would not be able to enhance the photoelectric conversion characteristics sufficiently in an environment of low illumination only by decreasing the concentration of I₃⁻ in the electrolyte. Further, the inventors of the present invention thought that in order to enhance the photoelectric conversion characteristics in an environment of low illumination, it is effective to increase the open circuit voltage, and in order to do so, it is necessary to decrease the leakage current. Also, the inventors of the present invention paid attention to the photosensitizing dyes that are adsorbed to the oxide semiconductor layer and conducted research. As a result, the inventors assumed that if a region in which nothing is adsorbed between the photosensitizing dyes that are adsorbed to the surface of the oxide semiconductor layer is increased, transfer of electrons from the oxide semiconductor layer to the electrolyte or the like is likely to occur in that region, and as a result, the leakage current would increase. Here, the inventors of the present invention considered adsorbing a co-adsorbent together with a photosensitizing dye called N719 or N3 onto the oxide semiconductor layer. However, there was an occasion in which when the photoelectric conversion efficiency was measured at an irradiance of 1 sun, which indicates the intensity of sunlight, a fairly low value was obtained. From this, it was anticipated that even lower photoelectric conversion efficiency would be obtained in an environment of low illumination. However, the inventors adsorbed a co-adsorbent having a particular structure, together with a photosensitizing dye such as N719 or N3, to an oxide semiconductor layer, and surprisingly, it was found that in an environment of low illumination, a dye-sensitized solar cell exhibits a photoelectric conversion efficiency that is fairly higher than the photoelectric conversion efficiency measured outdoors. Thus, the inventors of the present invention conducted research more assiduously, and as a result, they found that the problems described above can be solved by a combination of a photosensitizing dye having a particular structure and a particular co-adsorbent that adsorbs to an oxide semiconductor layer together with the photosensitizing dye, thus completing the present invention.

That is, the present invention is a dye-sensitized solar cell for low illumination, which includes a first electrode having a transparent substrate and a transparent conductive film provided on the transparent substrate; a second electrode that faces the first electrode; an oxide semiconductor layer provided on the first electrode or the second electrode; an electrolyte that is provided between the first electrode and the second electrode; a photosensitizing dye that is adsorbed to the oxide semiconductor layer; and a co-adsorbent that is adsorbed to the oxide semiconductor layer together with the photosensitizing dye, the photosensitizing dye being a metal complex compound represented by the following formula (1), and the co-adsorbent including two kinds of organic compounds selected from the group consisting of an organic compound represented by the following formula (2), an organic compound represented by the following formula (3), and an organic compound represented by the following formula (4) or comprising an organic compound selected from the organic compounds represented by formulas (2) to (4) and an organic compound represented by the following formula (X): 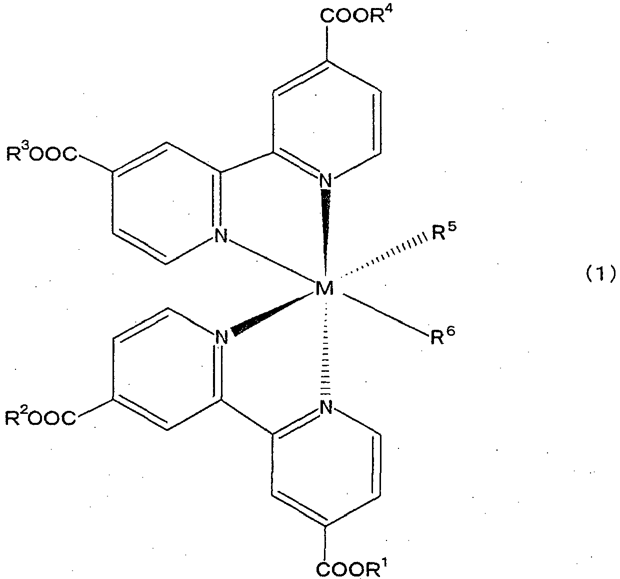 wherein in formula (1), M represents Ru; R¹, R², R³, and R⁴ each independently represent a monovalent cation; and R⁵ and R⁶ each independently represent a halogen group, -H, -CN, -NCS, or -NCO; 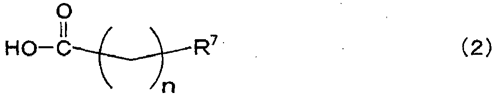 wherein in formula (2), n represents an integer from 0 to 5; and R⁷ represents a monovalent group having a π-conjugated structure or a monovalent group having a steroid skeleton; 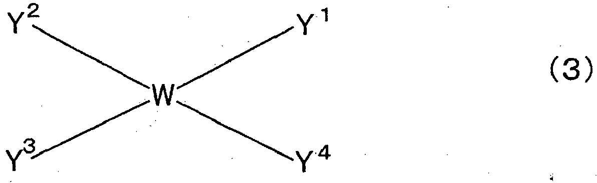 wherein in formula (3), W represents a carbon atom or a silicon atom; Y¹, Y², Y³, and Y⁴ each independently represent a hydrogen atom, a carboxyl group, a substituted or unsubstituted alkoxy group having 1 to 6 carbon atoms, or a substituted or unsubstituted hydrocarbon group having 3 to 20 carbon atoms; and one of Y¹, Y², Y³, and Y⁴ represents a substituted or unsubstituted hydrocarbon group having 3 to 20 carbon atoms, while at least two of the remaining groups each represent a carboxyl group or a substituted or unsubstituted alkoxy group having 1 to 6 carbon atoms; 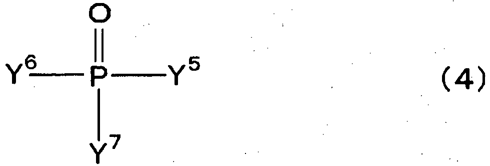 wherein in formula (4), Y⁵, Y⁶, and Y⁷ each independently represent a hydroxyl group or a substituted or unsubstituted hydrocarbon group having 3 to 20 carbon atoms; and one or two of Y⁵, Y⁶, and Y⁷ each represent a substituted or unsubstituted hydrocarbon group having 3 to 20 carbon atoms, while the others represent hydroxyl groups, and 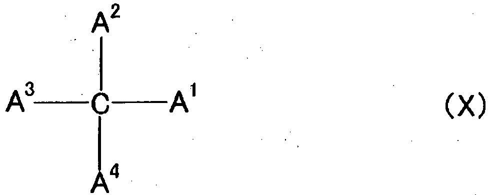 wherein in formula (X), A¹ to A³ each independently represent a hydrogen atom or a methyl group; and A⁴ represents a hydroxyl group or a carboxyl group.

According to the dye-sensitized solar cell of the present invention, a photosensitizing dye represented by the formula (1) is used as the photosensitizing dye. This photosensitizing dye has high absorption efficiency at short wavelengths. On the other hand, the light of indoor lightings such as fluorescent lamps includes a large amount of light of short wavelengths, and does not much include light of long wavelengths. Therefore, the photosensitizing dye represented by formula (1) is especially suitable as a photosensitizing dye for dye-sensitized solar cells for indoor use, and can realize superior photoelectric conversion characteristics as compared with black dye or Z907 having long side chains. Furthermore, the co-adsorbent includes at least one organic compound selected from the group consisting of an organic compound represented by the formula (2) described above, an organic compound represented by the formula (3) described below, and an organic compound represented by the formula (4) described below. Here, the organic compound represented by formula (2) has a monovalent group having a π-conjugated structure, or a monovalent group having a steroid skeleton. Here, the monovalent group having a π-conjugated structure and the monovalent group having a steroid skeleton both have a planar shape, and it is difficult for the groups to undergo deformation freely. Furthermore, in the organic compound represented by formula (3), one of Y¹, Y², Y³ and Y⁴ represents a substituted or unsubstituted hydrocarbon group having 3 to 20 carbon atoms, while at least two of the remaining groups each represent a carboxyl group or an alkoxy group. In this case, since at least two carboxyl groups or alkoxy groups adsorb to the oxide semiconductor layer, it is difficult for the organic compound represented by formula (3) to undergo deformation freely. Furthermore, the organic compound represented by formula (4) has a PO group. Here, P has an electronegativity that is lower than that of C (carbon atom) that is contained in the carboxyl group or alkoxy group. For this reason, it is difficult for a PO group to be ionized, and is not easily detached from the oxide semiconductor layer. Therefore, a PO group is securely adsorbed to the oxide semiconductor layer. Accordingly, similarly to the organic compound represented by formula (3), even if the organic compound does not have at least two carboxyl groups or the like, it is difficult for the organic compound to undergo deformation easily. As such, the co-adsorbent includes an organic compound that is not easily deformed freely when adsorbed to the surface of the oxide semiconductor layer. Accordingly, it is not necessary to provide a wasteful space for the co-adsorbent at the surface of the oxide semiconductor layer. Therefore, the photosensitizing dye can be sufficiently adsorbed to the surface of the oxide semiconductor layer. Furthermore, at the surface of the oxide semiconductor layer, the co-adsorbent can be adsorbed in the regions where the photosensitizing dye is not adsorbed. In the regions where the photosensitizing dye is not adsorbed at the surface of the oxide semiconductor layer, transfer of electrons between the oxide semiconductor layer and the electrolyte (reverse electron transfer) may occur, but, in the present invention, the reverse electron transfer can be sufficiently suppressed as the co-adsorbent adsorbs in those regions. As a result, leakage current can be reduced, and therefore, the open circuit voltage can be increased in an environment of low illumination. Therefore, the dye-sensitized solar cell for low illumination of the present invention acquires excellent photoelectric conversion characteristics.

In the dye-sensitized solar cell described above, it is preferable that in the organic compounds represented by formulas (2) to (4), the distance between the oxygen atom (O) of an OH group in each of the organic compounds represented by formulas (2) to (4) and the atom that is at the farthest position from the oxygen atom (O) be 0.7 nm to 3 nm.

In this case, since the length of the photosensitizing dye is about 1.5 nm, the leakage current can be more sufficiently reduced as compared with the case where the distance of the organic compound is less than 0.7 nm. Furthermore, as compared with the case where the distance of the organic compound is longer than 3 nm, injection of electrons from the electrolyte to the photosensitizing dye can easily occur, and the photoelectric conversion characteristics can be further enhanced.

Here, it is preferable that the co-adsorbent include, among the organic compounds selected from the organic compounds represented by formulas (2) to (4), a first organic compound in which a first distance between the oxygen atom of an OH group in any one of the organic compounds represented by formulas (2) to (4) and the atom that is at the farthest position from the oxygen atom is 0.7 nm to 3 nm; and among the organic compounds selected from the organic compounds represented by formulas (2) to (4) and formula (X), a second organic compound in which a second distance between the oxygen atom of an OH group in any one of the organic compounds represented by formulas (2) to (4) and formula (X) and the atom that is at the farthest position from the oxygen atom is 0.1 nm to 0.7 nm, and the first distance of the first organic compound be longer than the second distance of the second organic compound.

In this case, the second organic compound penetrates in between the first organic compounds, and thereby, association of the first organic compounds can be more sufficiently suppressed.

It is preferable that in R⁷ in the formula (2), the monovalent group having a π-conjugated structure be a monovalent group having a merocyanine skeleton, a phenyl skeleton, a guanidine skeleton, a pyridine skeleton, or a porphyrin skeleton, and the monovalent group having a steroid skeleton be a monovalent group represented by the following formula (5): 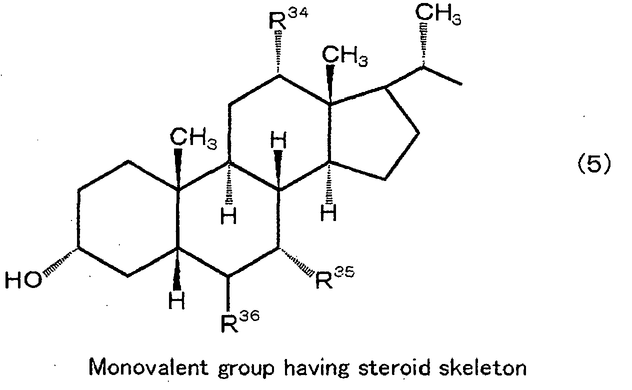 wherein in formula (5), R³⁴, R³⁵, and R³⁶ each independently represent a hydrogen atom or a hydroxyl group.

In this case, since the leakage current can be further reduced, the open circuit voltage can be further increased in an environment of low illumination.

In R⁷ in the formula (2), the monovalent group having a π-conjugated structure is preferably a monovalent group having a merocyanine skeleton or a guanidine skeleton. In this case, since the leakage current can be further reduced, the open circuit voltage can be further increased in an environment of low illumination.

It is preferable that in the formula (1) described above, at least one of R¹, R², R³ and R⁴ be a hydrogen ion. In this case, as ester bonds are included in the surface of the oxide semiconductor layer, the efficiency of electron injection into the oxide semiconductor layer is further increased.

It is preferable that in the formula (1), at least one of R¹, R², R³ and R⁴ be a hydrogen ion, and the others be a monovalent ammonium salt. In this case, the extinction coefficient is further increased.

In the formula (1), R⁵ and R⁶ are each preferably -NCS. In this case, the extinction coefficient is further increased, and the efficiency of electron injection from the electrolyte is further increased.

In the dye-sensitized solar cell for low illumination, the molar ratio of the co-adsorbent with respect to the photosensitizing dye is preferably 0.1 to 1.

When the molar ratio of the co-adsorbent with respect to the photosensitizing dye is in the range described above, the leakage current can be reduced more effectively, and also the generated current can be further increased, as compared with the case where the molar ratio is not in the aforementioned range.

It is preferable that in the dye-sensitized solar cell for low illumination, the electrolyte contain a redox couple composed of I⁻ and I₃⁻, and the concentration of I₃⁻ in the electrolyte be 0.006 mol/liter or less.

In this case, since the concentration of I₃⁻ that transfers electrons is low, the leakage current can be further reduced, and the open circuit voltage can be further increased. Accordingly, the photoelectric conversion characteristics can be further enhanced.

Meanwhile, in the present invention, the term "low illumination" means a light intensity of 10,000 Lux or less.

### EFFECTS OF INVENTION

According to the present invention, there is provided a dye-sensitized solar cell for low illumination having excellent photoelectric conversion characteristics in an environment of low illumination.

### BRIEF DESCRIPTION OF DRAWINGS

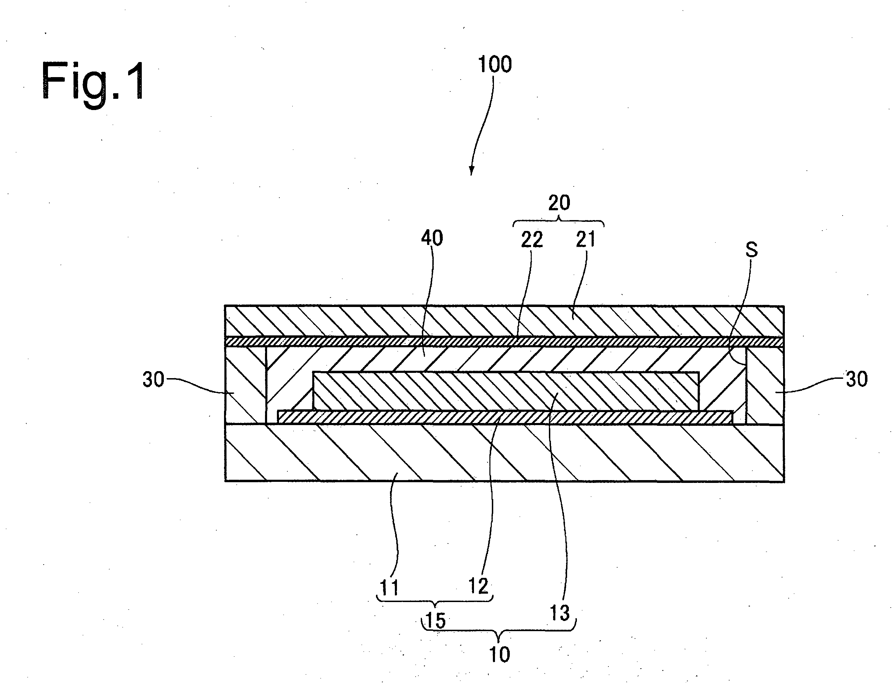

Fig. 1 is a cross-sectional diagram illustrating an embodiment of the dye-sensitized solar cell for low illumination of the present invention.

### MODES FOR CARRYING OUT THE INVENTION

Hereinafter, embodiments of the present invention will be described in detail with reference to the drawings.

Fig. 1 is a cross-sectional diagram illustrating an embodiment of the dye-sensitized solar cell of the present invention.

As illustrated in Fig. 1, the dye-sensitized solar cell 100 is a dye-sensitized solar cell that is used in an environment of low illumination, and includes a working electrode 10, a counter electrode 20 that faces the working electrode 10, and an annular sealing section 30 that connects the working electrode 10 and the counter electrode 20, while an electrolyte 40 is filled in a cell space S that is formed by the working electrode 10, counter electrode 20 and sealing section 30.

The working electrode 10 includes a transparent conductive substrate 15 composed of a transparent substrate 11 and a transparent conductive film 12 that is provided on the transparent substrate 11, and at least one oxide semiconductor layer 13 that is provided on the transparent conductive film 12 of the transparent conductive substrate 15. The oxide semiconductor layer 13 is disposed on the inner side of the sealing section 30. Furthermore, in the oxide semiconductor layer 13, a photosensitizing dye and a co-adsorbent are adsorbed together. In the present embodiment, a first electrode is constituted by the transparent conductive substrate 15, and a second electrode is constituted by the counter electrode 20.

Here, as the photosensitizing dye, a metal complex compound represented by the following formula (1) is used. The co-adsorbent includes two kinds of organic compounds represented by the following formula (2), an organic compound represented by the following formula (3), or an organic compound represented by the following formula (4). 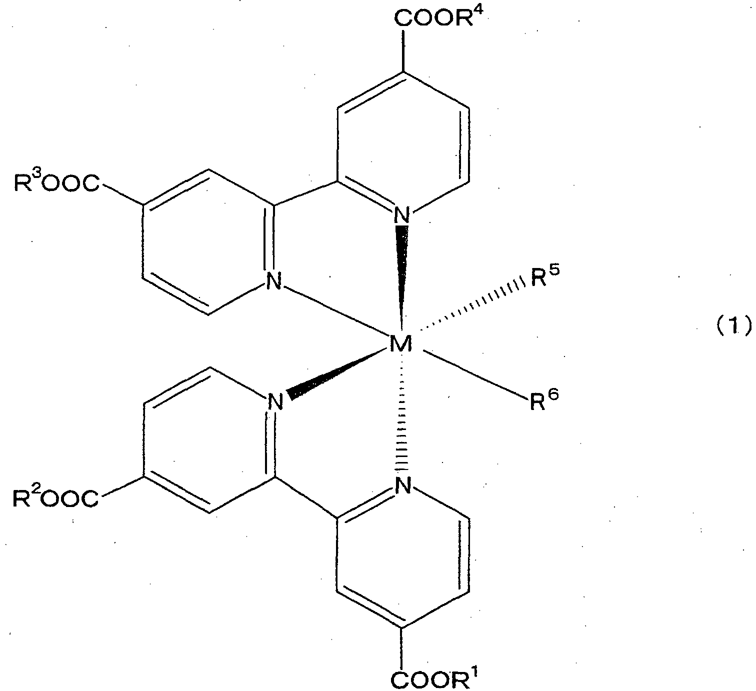 wherein in formula (1), M represents Ru; R¹, R², R³ and R⁴ each independently represent a monovalent cation; and R⁵ and R⁶ each independently represent a halogen group, -H, -CN, -NCS or -NCO; 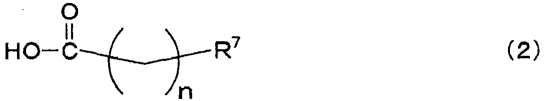 wherein in formula (2), n represents an integer from 0 to 5; and R⁷ represents a monovalent group having a π-conjugated group or a monovalent group having a steroid skeleton; 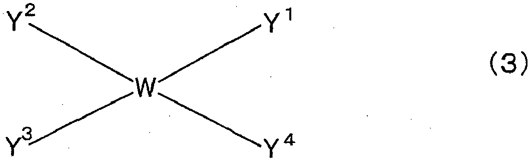 wherein in formula (3), W represents a carbon atom or a silicon atom; Y¹, Y², Y³ and Y⁴ each independently represent a hydrogen atom, a carboxyl group, a substituted or unsubstituted alkoxy group having 1 to 6 carbon atoms, or a substituted or unsubstituted hydrocarbon group having 3 to 20 carbon atoms; one of Y¹, Y², Y³ and Y⁴ represents a substituted or unsubstituted hydrocarbon group having 3 to 20 carbon atoms, while at least two of the remaining groups each represent a carboxyl group or a substituted or unsubstituted alkoxy group having 1 to 6 carbon atoms; and 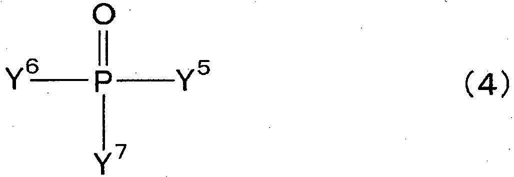 wherein in formula (4), Y⁵, Y⁶ and Y⁷ each independently represent a hydroxyl group or a substituted or unsubstituted hydrocarbon group having 3 to 20 carbon atoms; and one or two of Y⁵, Y⁶ and Y represent substituted or unsubstituted hydrocarbon groups having 3 to 20 carbon atoms, while the others represent hydroxyl groups.

The counter electrode 20 includes a conductive substrate 21, and a catalyst layer 22 that is provided on the working electrode 10 side of the conductive substrate 21 and accelerates a catalytic reaction.

According to the dye-sensitized solar cell for low illumination 100 described above, a photosensitizing dye represented by the above formula (1) is used as the photosensitizing dye. This photosensitizing dye has high absorption efficiency at short wavelengths. On the other hand, indoor light such as fluorescent lamp light include a large amount of light of short wavelengths, and does not much include light of long wavelengths. Therefore, the photosensitizing dye represented by formula (1) is especially suitable as a photosensitizing dye for dye-sensitized solar cells for indoor use, and can realize superior photoelectric conversion characteristics as compared with black dye or Z907 having long side chains. Furthermore, the co-adsorbent includes two kinds selected from the group consisting of an organic compound represented by the formula (2) described above, an organic compound represented by the formula (3) described below, and an organic compound represented by the formula (4) described below. Here, the organic compound represented by formula (2) has a monovalent group having a π-conjugated structure, or a monovalent group having a steroid skeleton. Here, the monovalent group having a π-conjugated structure and the monovalent group having a steroid skeleton both have a planar shape, and it is difficult for the groups to undergo deformation freely. Furthermore, in the organic compound represented by formula (3), one of Y¹, Y², Y³ and Y⁴ represents a substituted or unsubstituted hydrocarbon group having 3 to 20 carbon atoms, while at least two of the remaining groups each represent a carboxyl group or an alkoxy group. In this case, since at least two carboxyl groups or alkoxy groups adsorb to the oxide semiconductor layer 13, it is difficult for the organic compound represented by formula (3) to undergo deformation freely. Furthermore, the organic compound represented by formula (4) has a PO group. Here, P has an electronegativity that is lower than that of C (carbon atom) that is contained in the carboxyl group or alkoxy group. For this reason, it is difficult for a PO group to be ionized, and is not easily detached from the oxide semiconductor layer 13. Therefore, a PO group is securely adsorbed to the oxide semiconductor layer 13. Accordingly, similarly to the organic compound represented by formula (3), even if the organic compound does not have at least two carboxyl groups or the like, it is difficult for the organic compound to undergo deformation easily. As such, the co-adsorbent includes an organic compound that is not easily deformed freely when adsorbed to the surface of the oxide semiconductor layer 13. Accordingly, it is not necessary to provide a space for the co-adsorbent wastefully at the surface of the oxide semiconductor layer 13. Therefore, the photosensitizing dye can be sufficiently adsorbed to the surface of the oxide semiconductor layer 13. Furthermore, at the surface of the oxide semiconductor layer 13, the co-adsorbent can be adsorbed in the regions where the photosensitizing dye is not adsorbed. In the regions where the photosensitizing dye is not adsorbed at the surface of the oxide semiconductor layer 13, transfer of electrons between the oxide semiconductor layer 13 and the electrolyte 40 (reverse electron transfer) may occur, and thus, in the dye-sensitized solar cell 100, the reverse electron transfer can be sufficiently suppressed as the co-adsorbent adsorbs in those regions. As a result, leakage current can be reduced, and therefore, the open circuit voltage can be increased in an environment of low illumination. Therefore, the dye-sensitized solar cell for low illumination 100 acquires excellent photoelectric conversion characteristics.

Meanwhile, the photosensitizing dye used in the dye-sensitized solar cell for low illumination 100 has high absorption efficiency at short wavelengths as described above, and can realize superior photoelectric conversion characteristics as compared with black dye or Z907 having long side chains. On the other hand, indoor light such as fluorescent lamp light include a large amount of light of short wavelengths, and does not much include light of long wavelengths. Therefore, the dye-sensitized solar cell for low illumination 100 is particularly suitable as a dye-sensitized solar cell for indoor use.

Next, the working electrode 10, counter electrode 20, sealing section 30, electrolyte 40, photosensitizing dye and co-adsorbent will be described in detail.

### (Working electrode)

The working electrode 10 includes, as described above, a transparent substrate 11, a transparent conductive film 12 that is provided on the transparent substrate 11, and at least one oxide semiconductor layer 13 that is provided on the transparent conductive film 12.

The material that constitutes the transparent substrate 11 may be, for example, a transparent material, and examples of such a transparent material include glasses such as borosilicate glass, soda lime glass, glass which is made of soda lime and whose iron component is less than that of ordinary soda lime glass, and quartz glass; polyethylene terephthalate (PET), polyethylene naphthalate (PEN), polycarbonate (PC), and polyether sulfone (PES). The thickness of the transparent substrate 11 is appropriately determined depending on the size of the dye-sensitized solar cell for low illumination 100, and is not particularly limited; however, the thickness may be adjusted, for example, to the range of 50 µm to 10,000 µm.

Examples of the material that constitutes the transparent conductive film 12 include electroconductive metal oxides such as tin-doped indium oxide (Indium-Tin-Oxide: ITO), tin oxide (SnO₂), and fluorine-added tin oxide (Fluorine-doped-tin-oxide: FTO). The transparent conductive film 12 may be constituted of a single layer, or may be constituted of a laminate of plural layers formed from different electroconductive metal oxides. When the transparent conductive film 12 is constituted of a single layer, since the transparent conductive film 12 has high heat resistance and high chemical resistance, it is preferable that the transparent conductive film 12 be formed of FTO. Furthermore, when a laminate constituted of plural layers is used as the transparent conductive film 12, it is preferable because the characteristics of the various layers can be reflected. Particularly, it is preferable to use a laminate of a layer formed of ITO and a layer formed of FTO. In this case, a transparent conductive film 12 having high electrical conductivity, heat resistance and chemical resistance can be realized. The thickness of the transparent conductive film 12 may be adjusted to, for example, 0.01 µm to 2 µm.

The oxide semiconductor layer 13 is composed of oxide semiconductor particles. Examples of the oxide semiconductor particles include particles of titanium oxide (TiO₂), zinc oxide (ZnO), tungsten oxide (WO₃), niobium oxide (Nb₂O₅), strontium titanate (SrTiO₃), tin oxide (SnO₂), indium oxide (In₃O₃), zirconium oxide (ZrO₂), thallium oxide (Ta₂O₅), lanthanum oxide (La₂O₃), yttrium oxide (Y₂O₃), holmium oxide (HO₂O₃), bismuth oxide (Bi₂O₃), cerium oxide (CeO₂), aluminum oxide (Al₂O₃), or two or more kinds thereof.

The thickness of the oxide semiconductor layer 13 may be, for example, 0.5 µm to 50 µm.

### (Counter electrode)

The counter electrode 20 includes, as described above, a conductive substrate 21, and a conductive catalyst layer 22 that is provided on the working electrode 10 side in the conductive substrate 21 and accelerates a reduction reaction at the surface of the counter electrode 20.

The conductive substrate 21 is constituted of, for example, a corrosion resistant metal material such as titanium, nickel, platinum, molybdenum or tungsten, or a product having a film formed of a conductive oxide such as ITO or FTO formed on the transparent substrate 11 described above. The thickness of the conductive substrate 21 is appropriately determined according to the size of the dye-sensitized solar cell 100 for low illumination and is not particularly limited; however, the thickness may be, for example, 0.005 mm to 0.1 mm.

The catalyst layer 22 is formed of platinum, a carbon-based material, or an electroconductive polymer. Here, as the carbon-based material, carbon nanotubes are suitably used.

### (Sealing section)

As the sealing section 30, for example, resins such as an ionomer, an ethylene-anhydrous vinyl acetate copolymer, an ethylene-methacrylic acid copolymer, an ethylene-vinyl alcohol copolymer, a resin cured by an ultraviolet ray, and a polyvinyl alcohol may be used.

### (Electrolyte)

The electrolyte 40 contains, for example, a redox couple such as I⁻/I₃⁻, and an organic solvent. Examples of the organic solvent that can be used include acetonitrile, methoxyacetonitrile, methoxypropionitrile, propionitrile, ethylene carbonate, propylene carbonate, diethyl carbonate, and γ-butyrolactone. Examples of the redox couple include couples of I⁻/I₃⁻ and bromine/bromide ion. Meanwhile, a gelling agent may also be added to the volatile solvent. Furthermore, the electrolyte 40 may be composed of an ionic liquid electrolyte formed from a mixture of an ionic liquid and a volatile component. Examples of the ionic liquid include a normal temperature molten salt that is already known iodine salts such as pyridinium salt, imidazolium salt and triazolium salt, and that is in a molten state at near room temperature. As such a normal temperature molten salt, for example, 1-ethyl-3-methylimidazolium bis(trifluoromethylsulfonyl)imide is suitably used. Furthermore, examples of the volatile component include the organic solvents described above; LiI, I₂, 4-t-butylpyridine, and N-methylbenzimidazole.

Meanwhile, the electrolyte 40 contains a redox couple composed of I⁻/I₃⁻, and the concentration of I₃⁻ is preferably 0.006 mol/liter or less, more preferably 0 to 6×10⁻⁶ mol/liter, and even more preferably 0 to 6×10⁻⁸ mol/liter. In this case, since the concentration of I₃⁻ that transfers electrons is low, the leakage current can be further reduced. Accordingly, since the open circuit voltage can be further increased, the photoelectric conversion characteristics can be further enhanced.

### (Photosensitizing dye)

As the photosensitizing dye, as described above, a metal complex compound represented by the following formula (1) is used.

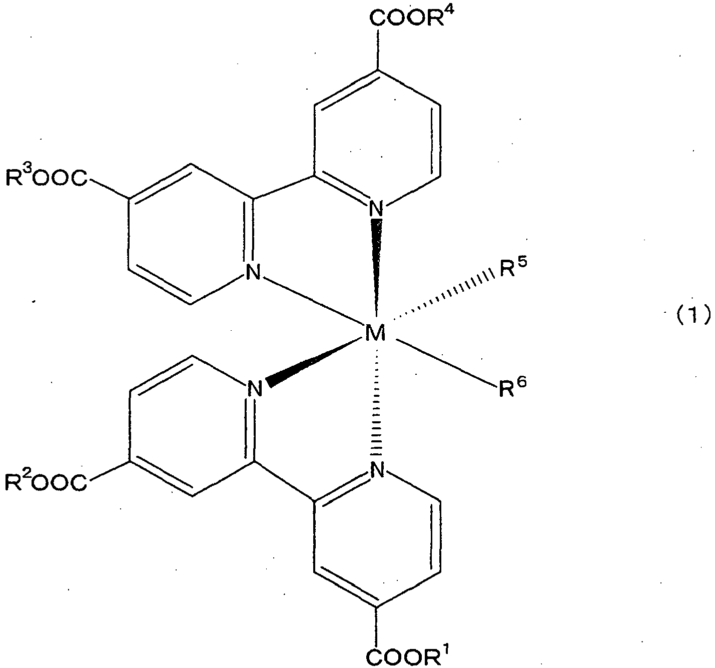

In formula (1), M represents Ru; R¹, R², R³ and R⁴ each independently represent a monovalent cation; and R⁵ and R⁶ each independently represent a halogen group, -H, -CN, -NCS or -NCO.

Examples of the monovalent cation include a hydrogen ion, a monovalent ammonium salt, and sodium ion.

Among them, it is preferable that R¹, R², R³ and R⁴ all represent hydrogen ions. In this case, the photosensitizing dye can be easily synthesized, and can be manufactured at low cost.

Furthermore, it is also acceptable that at least one of R¹, R², R³ and R⁴ represents a hydrogen ion, and the others represent ammonium salts. In this case, the extinction coefficient is further increased.

The ammonium salt is represented by the following formula (6) :

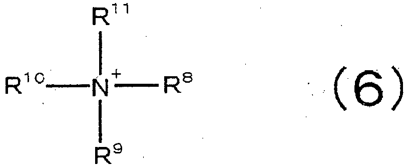

In formula (6), R⁸, R⁹, R¹⁰ and R¹¹ each independently represent a hydrogen atom or a substituted or unsubstituted hydrocarbon group having 1 to 6 carbon atoms.

The hydrocarbon group may be a linear or branched, and examples of the hydrocarbon group include alkyl groups such as a methyl group, an ethyl group, a propyl group, a butyl group, a pentyl group, and a hexyl group; a vinyl group; cycloalkyl groups such as a cyclopentyl group and a cyclohexyl group; and aryl groups such as a phenyl group or a naphthyl group. A substituted hydrocarbon group is a hydrocarbon group having a hydrogen atom substituted by another substituent, and examples of such a substituent include halogen groups such as -Cl, -F, and -I.

Here, it is preferable that R⁸, R⁹, R¹⁰ and R¹¹ be all hydrocarbon groups composed of butyl groups. In this case, the extinction coefficient is further increased as compared with the case where all of R⁸, R⁹, R¹⁰ and R¹¹ are not butyl groups.

Furthermore, in formula (1), examples of the halogen group for R⁵ and R⁶ include -Cl, -Br, -I and -F, but among them, -I is preferred.

It is preferable that R⁵ and R⁶ be -NCS, since the extinction coefficient is further increased, and the efficiency of electron injection from the electrolyte 40 is further increased.

### (Co-adsorbent)

As the co-adsorbent, as described previously, for example, an organic compound represented by the following formula (2) is used. Here, the organic compound is composed of non-metal atoms only.

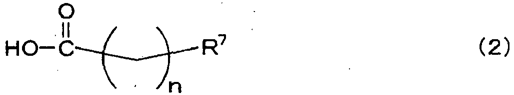

In formula (2), n represents an integer from 0 to 5; and R⁷ represents a monovalent group having a π-conjugated structure, or a monovalent group having a steroid skeleton.

In R⁷ in the formula (2), examples of the monovalent group having a π-conjugated structure include monovalent groups having a merocyanine skeleton, a phenyl skeleton, a guanidine skeleton, a pyridine skeleton and a porphyrin skeleton.

Here, the monovalent group having a merocyanine skeleton is represented by the following formula (7):

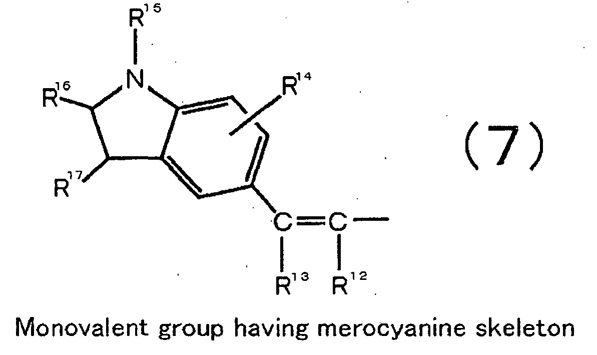

In formula (7), R¹² represents a hydrogen atom, -CN, or a hydrocarbon group having 1 to 5 carbon atoms; R¹³, R¹⁴, R¹⁶ and R¹⁷ each represent a hydrogen atom or a hydrocarbon group having 1 to 5 carbon atoms; and R¹⁵ represents a phenyl group substituted with an alkoxy group having 1 to 5 carbon atoms, or is represented by the following formula (8). R¹⁶ and R¹⁷ may be bonded to each other and form a 5-membered ring or a 6-memebred ring.

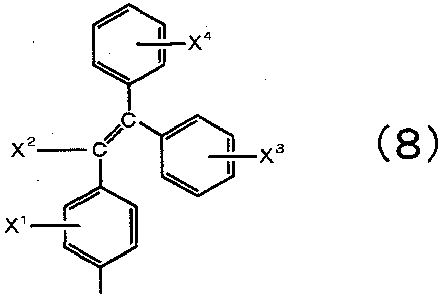

In formula (8), X¹, X², X³ and X⁴ each independently represent a hydrogen atom or a hydrocarbon group having 1 to 5 carbon atoms.

The hydrocarbon group may be linear or branched, and examples of the hydrocarbon group include alkyl groups such as a methyl group, an ethyl group, a propyl group, a butyl group and a pentyl group; a vinyl group; cycloalkyl groups such as a cyclopentyl group; and aryl groups such as a phenyl group or a naphthyl group. A substituted hydrocarbon group is a hydrocarbon group having a hydrogen atom substituted by another substituent, and examples of such a substituent include halogen groups such as - Cl, -F and -I.

The monovalent group having a phenyl skeleton (phenyl group) is represented by the following formula (9):

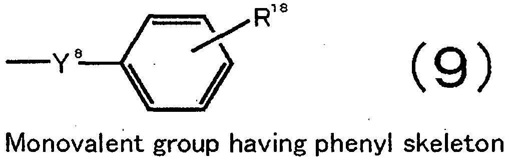

In formula (9), R¹⁸ represents a hydrogen atom, a hydroxyl group, or a substituted or unsubstituted hydrocarbon group having 1 to 6 carbon atoms; Y⁸ represents a single bond, or -CY⁹(Y¹⁰)CO-. Y⁹ and Y¹⁰ each independently represent a hydrogen atom, or a substituted or unsubstituted hydrocarbon group having 1 to 6 carbon atoms.

The hydrocarbon group may be linear or branched, and as the hydrocarbon group, for example, the same groups as the hydrocarbon groups for formula (6) can be used. Furthermore, as the substituent for the substituted hydrocarbon, for example, the same substituents as the substituents of the hydrocarbon group for formula (6) can be used.

The monovalent group having a guanidine skeleton (guanidyl group) is represented by the following formula (10):

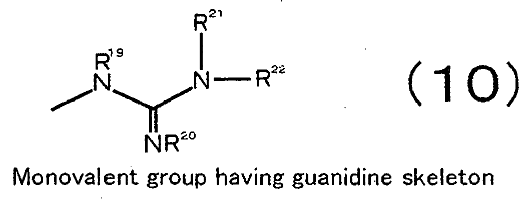

In formula (10), R¹⁹, R²⁰, R²¹ and R²² each independently represent a hydrogen atom, or a substituted or unsubstituted hydrocarbon group having 1 to 6 carbon atoms.

The hydrocarbon group may be linear or branched, and as the hydrocarbon group, for example, the same groups as the hydrocarbon groups for formula (6) can be used. Furthermore, as the substituent for the substituted hydrocarbon, for example, the same substituents as the substituents of the hydrocarbon group for formula (6) can be used.

The monovalent group having a pyridine skeleton (pyridyl group) is represented by the following formula (11):

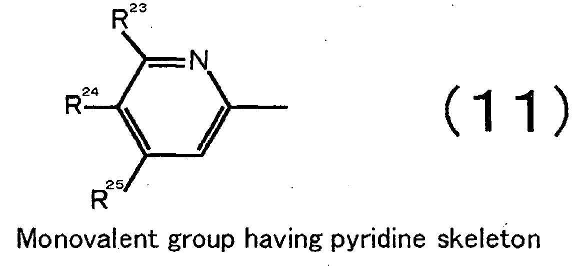

In formula (11), R²³, R²⁴ and R²⁵ each independently represent a hydrogen atom or a substituted or unsubstituted hydrocarbon group having 1 to 6 carbon atoms; and R²³ and R²⁴ may be bonded to each other and form a 5-membered or 6-membered ring.

The hydrocarbon group may be linear or branched, and as the hydrocarbon group, for example, the same groups as the hydrocarbon groups for formula (6) can be used. Furthermore, as the substituent for the substituted hydrocarbon, the same substituents as the substituents of the hydrocarbon group for formula (6) can be used.

The monovalent group having a porphyrin skeleton is represented by, for example, the following formula (12):

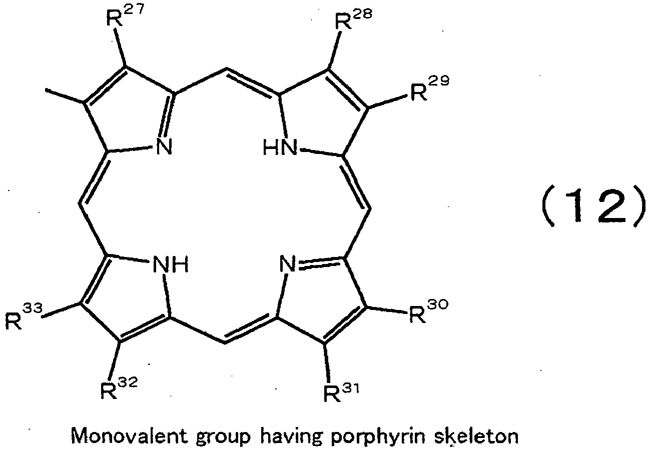

In formula (12), R²⁷ R²⁸, R²⁹, R³⁰, R³¹, R³² and R³³ each independently represent a hydrogen atom or a substituted or unsubstituted hydrocarbon group having 1 to 6 carbon atoms.

The hydrocarbon group may be linear or branched, and as the hydrocarbon group, for example, the same groups as the hydrocarbon groups for formula (6) can be used. Furthermore, as the substituent for the substituted hydrocarbon, the same substituents as the substituents of the hydrocarbon group for formula (6) can be used.

Furthermore, as the monovalent group having a steroid skeleton, for example, a monovalent group represented by the following formula (5) is used:

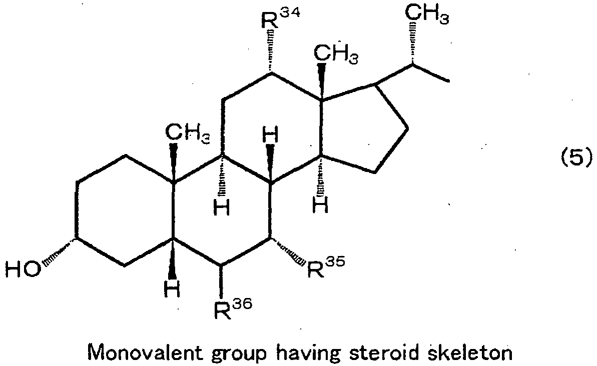

In formula (5), R³⁴, R³⁵ and R³⁶ each independently represent a hydrogen atom or a hydroxyl group.

In formula (2), n represents an integer from 0 to 5. n is preferably an integer from 0 to 3, and more preferably an integer from 0 to 2.

Specific examples of a co-adsorbent having a merocyanine skeleton include, for example, organic compounds represented by the following structural formula (A) and the following structural formula (B):

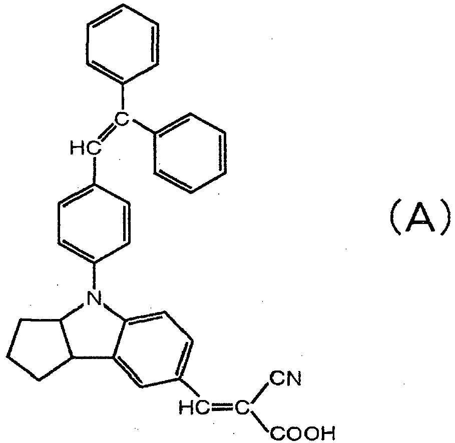

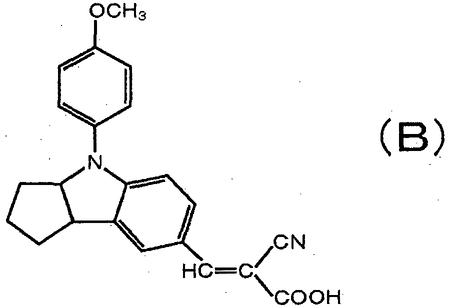

Specific examples of a co-adsorbent having a phenyl skeleton include, for example, 3-phenylpropionic acid and 4-hydroxyphenylpyruvic acid.

Specific examples of a co-adsorbent having a guanidine skeleton include, for example, 4-guanidinobutanoic acid.

Specific examples of a co-adsorbent having a pyridine skeleton include, for example, 2,3-pyridinedicarboxylic acid, 5-tert-butyl-2-pyridinecarboxylic acid, and 3-pyridinecarboxylic acid.

Specific examples of a co-adsorbent having a porphyrin skeleton include, for example, a compound represented by the following structural formula (C):

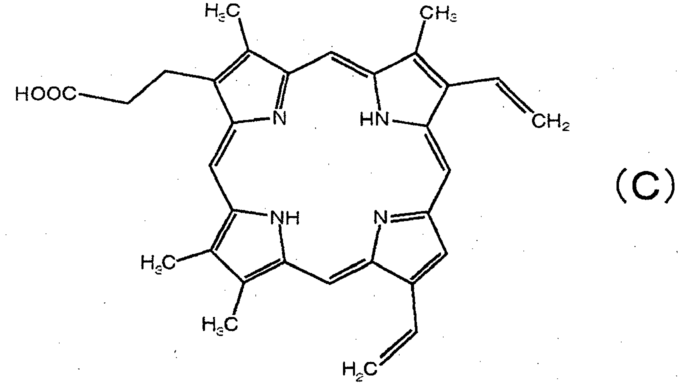

Alternatively, the co-adsorbent having a porphyrin skeleton may be a compound represented by the following structural formula (D):

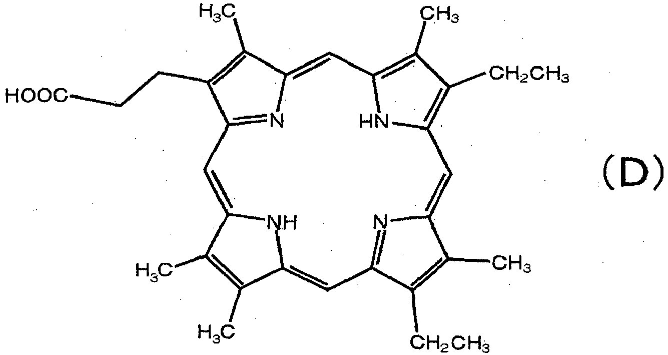

Specific examples of a co-adsorbent having a steroid skeleton include, for example, deoxycholic acid, kenodeoxycholic acid, cholic acid, and hyodeoxycholic acid.

Furthermore, as the co-adsorbent, as previously described, an organic compound represented by the following formula (3) can also be used:

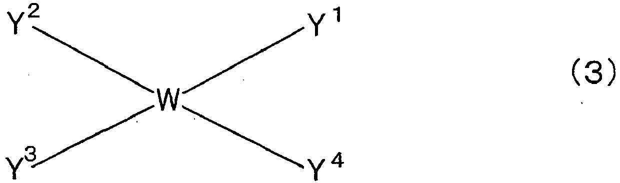

In formula (3), W represents a carbon atom or a silicon atom; Y¹, Y², Y³ and Y⁴ each independently represent a hydrogen atom, a carboxyl group, a substituted or unsubstituted alkoxy group having 1 to 6 carbon atoms, or a substituted or unsubstituted hydrocarbon group having 3 to 20 carbon atoms; one of Y¹, Y², Y³ and Y⁴ represents a substituted or unsubstituted hydrocarbon group having 3 to 20 carbon atoms, while at least two of the remaining groups each represent a carboxyl group or a substituted or unsubstituted alkoxy group having 1 to 6 carbon atoms.

Here, when W is a silicon atom, it is preferable that at least one of Y¹, Y², Y³ and Y⁴ represent a substituted or unsubstituted hydrocarbon group having 3 to 20 carbon atoms, and at least two of the remaining groups each represent a substituted or unsubstituted alkoxy group having 1 to 6 carbon atoms. In this case, detachment of the co-adsorbent from oxide semiconductor layer 13 occurs with more difficulties.

When W is a carbon atom, it is preferable that at least one of Y¹, Y², Y³ and Y⁴ represent a substituted or unsubstituted hydrocarbon group having 3 to 20 carbon atoms, and at least two of the remaining groups each represent a carboxyl group. In this case, detachment of the co-adsorbent from oxide semiconductor layer 13 occurs with more difficulties.

The hydrocarbon group may be linear or branched, and as the hydrocarbon group, for example, the same groups as the hydrocarbon groups for formula (6) can be used. Furthermore, as the substituent for the substituted hydrocarbon, the same substituents as the substituents of the hydrocarbon group for formula (6) can be used.

Specific examples of the organic compound represented by formula (3) include, for example, 2-hexadecylmalonic acid (HDMA), decyltrimethoxysilane, and trifluoropropyltrimethoxysilane.

Furthermore, as the co-adsorbent, as previously described, an organic compound represented by the following formula (4) can also be used.

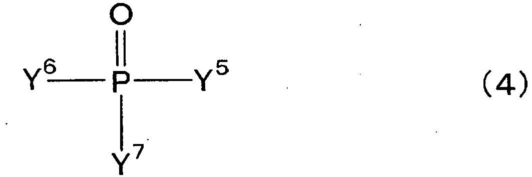

In formula (4), Y⁵, Y⁶ and Y⁷ each independently represent a hydroxyl group, or a substituted or unsubstituted hydrocarbon group having 3 to 20 carbon atoms; and one or two of Y⁵, Y⁶ and Y⁷ each represent a substituted or unsubstituted hydrocarbon group having 3 to 20 carbon atoms, while the others represent hydroxyl groups.

Here, it is acceptable that one of Y⁵, Y⁶ and Y⁷ represents a hydroxyl group, while the others represent the hydrocarbon groups described above; however, it is preferable that two of Y⁵, Y⁶ and Y⁷ represent hydroxyl groups, while the other represents the hydrocarbon group described above. In this case, detachment of the co-adsorbent from the oxide semiconductor layer 13 occurs with more difficulties.

The hydrocarbon group may be linear or branched, and as the hydrocarbon group, for example, the same groups as the hydrocarbon groups for formula (6) can be used. Furthermore, as the substituent for the substituted hydrocarbon, the same substituents as the substituents of the hydrocarbon group for formula (6) can be used.

Specific examples of the organic compound represented by formula (4) include, for example, bis(3,3-dimethylbutyl)phosphinic acid (DINHOP) and n-decylphosphonic acid (DPA).

The distance between the oxygen atom (O) of an OH group in the organic compounds represented by formulas (2) to (4) and the atom that is at the farthest position from the oxygen atom (O) is preferably 0.7 nm to 3 nm. In this case, since the length of the photosensitizing dye is about 1.5 nm, the leakage current can be more sufficiently reduced as compared with the case where the distance of the organic compounds represented by formulas (2) to (4) is less than 0.7 nm. Furthermore, as compared with the case where the distance of the organic compounds represented by formulas (2) to (4) is greater than 3.0 nm, injection of electrons from the electrolyte 40 to the photosensitizing dye can be more easily carried out, and the photoelectric conversion characteristics of the dye-sensitized solar cell 100 for low illumination can be further enhanced.

Here, the distance between the oxygen atom (O) of an OH group in the organic compounds represented by formulas (2) to (4) and the atom that is at the farthest position from the oxygen atom (O) in the co-adsorbent can be calculated from the molecular formula.

In the dye-sensitized solar cell 100, the co-adsorbent may include two kinds of organic compounds selected from the organic compounds represented by formulas (2) to (4).

Here, it is preferable that the co-adsorbent includes, among the organic compounds represented by formulas (2) to (4), a first organic compound in which a first distance between the oxygen atom of an OH group in any one of the organic compounds represented by formulas (2) to (4) and the atom that is at the farthest position from the oxygen atom is 0.7 nm to 3 nm; and among the organic compounds represented by formulas (2) to (4), a second organic compound in which a second distance between the oxygen atom of an OH group in any one of the organic compounds represented by formulas (2) to (4) and the atom that is at the farthest position from the oxygen atom is 0.1 nm to 0.7 nm, and the first distance of the first organic compound be longer than the second distance of the second organic compound.

In this case, the second organic compound penetrates in between the first organic compounds, and association between the first organic compounds can be more sufficiently suppressed.

Alternatively, in the dye-sensitized solar cell 100, the co-adsorbent may include organic compounds represented by formulas (2) to (4) and an organic compound represented by the following formula (X): 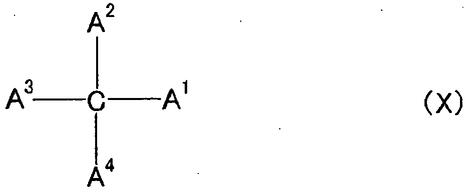 wherein in formula (X), A¹ to A³ each independently represent a hydrogen atom or a methyl group; and A⁴ represents a hydroxyl group or a carboxyl group.

Here, it is preferable that the co-adsorbent include, among the organic compounds represented by formulas (2) to (4), a first organic compound in which a first distance between the oxygen atom of an OH group in any one of the organic compounds represented by formulas (2) to (4) and the atom that is at the farthest position from the oxygen atom is 0.7 nm to 3 nm; and among the organic compounds represented by formula (X), a second organic compound in which a second distance between the oxygen atom of an OH group in the organic compounds represented by formula (X) and the atom that is at the farthest position from the oxygen atom is 0.1 nm to 0.7 nm, and the first distance of the first organic compound be longer than the second distance of the second organic compound.

In this case, the second organic compound penetrates in between the first organic compounds, and association of the molecules of the first organic compound can be more sufficiently suppressed.

Meanwhile, the first distance of the first organic compound is preferably 0.7 nm to 2 nm, and the second distance of the second organic compound is preferably 0.1 nm to 0.5 nm.

Specific examples of the first organic compound include, for example, deoxycholic acid (1.5 nm), kenodeoxycholic acid (1.5 nm), cholic acid (1.5 nm), 4-guanidinobutanoic acid (1 nm), 3-phenylpropionic acid (0.9 nm), 2,3-pyridinedicarboxylic acid (0.9 nm), 2-hexadecylmalonic acid (HDMA), bis(3,3-dimethylbutyl)phosphinic acid (DINHOP) and 5-tert-butyl-2-pyridinecarboxylic acid. Furthermore, the values within the parentheses represent the values of the first distance. The first distances of 2-hexadecylmalonic acid (HDMA) and bis(3,3-dimethylbutyl)phosphinic acid (DINHOP) are 0.9 to 1.4 nm, respectively.

Specific examples of the second organic compound include, for example, t-butyl alcohol (0.4 nm) and 2,2-dimethylpropanoic acid (0.6 nm). Meanwhile, the values within the parentheses represent the values of the second distance.

Here, the molar ratio of the second organic compound with respect to the first organic compound is preferably 0.5 to 10, and more preferably 1 to 5. In this case, the leakage current can be more effectively reduced as compared with the case where the molar range is not in the range described above.

The molar ratio of the co-adsorbent with respect to the photosensitizing dye is usually 0.05 to 2, and preferably 0.1 to 1. When the molar ratio of the co-adsorbent with respect to the photosensitizing dye is in the range described above, the leakage current can be more effectively reduced, and also, the generated current can be further increased, as compared with the case where the molar ratio is not in the range described above.

Next, the method for producing the dye-sensitized solar cell 100 for low illumination will be described.

First, a transparent conductive substrate 15 that is obtained by forming a transparent conductive film 12 on one transparent substrate 11, is prepared.

As the method for forming the transparent conductive film 12, a sputtering method, a vapor deposition method, a spray pyrolysis deposition method (SPD), a CVD method and the like are used.

Next, an oxide semiconductor layer 13 is formed on the transparent conductive film 12. The oxide semiconductor layer 13 is formed by printing a paste for forming a porous oxide semiconductor layer which contains oxide semiconductor particles, and then calcining the paste.

The paste for forming a porous oxide semiconductor layer contains, in addition to the oxide semiconductor particles described above, resins such as polyethylene glycol, and solvents such as terpineol.

As the method for printing the paste for forming an oxide semiconductor layer, for example, a screen printing method, a doctor blade method, a bar coating method or the like can be used.

The calcination temperature may vary depending on the material of the oxide semiconductor particles, but the calcination temperature is usually 350°C to 600°C. The calcination time may also vary depending on the material of the oxide semiconductor particles, but the calcination time is usually 1 hour to 5 hours.

In this manner, a working electrode 10 is obtained.

Next, the photosensitizing dye described above is adsorbed onto the surface of the oxide semiconductor layer 13 of the working electrode 10. To this end, a photosensitizing dye may be adsorbed to the oxide semiconductor layer 13 by immersing the working electrode 10 in a solution containing the photosensitizing dye, thus adsorbing the photosensitizing dye to the oxide semiconductor layer 13, subsequently washing away any excess photosensitizing dye with the solvent component of the solution, and drying the working electrode. However, the photosensitizing dye may also be adsorbed to the oxide semiconductor layer 13 by applying a solution containing the photosensitizing dye on the oxide semiconductor layer 13, and then drying the solution.

Next, the co-adsorbent described above is adsorbed onto the surface of the oxide semiconductor layer 13 of the working electrode 10. To this end, the co-adsorbent may be adsorbed to the surface of the oxide semiconductor layer 13 by immersing the working electrode 10 in a solution containing the co-adsorbent, thus adsorbing the co-adsorbent to the oxide semiconductor layer 13, subsequently washing away any excess co-adsorbent with the solvent component of the solution, and drying the working electrode. However, the co-adsorbent may also be adsorbed to the oxide semiconductor layer 13 by applying a solution containing the co-adsorbent on the oxide semiconductor layer 13, and then drying the solution.

At this time, the co-adsorbent is adsorbed to a region on the surface of the oxide semiconductor layer 13 where the photosensitizing dye is not adsorbed.

Meanwhile, the co-adsorbent may also be mixed with the photosensitizing dye and simultaneously adsorbed onto the surface of the oxide semiconductor layer 13. In this case, the oxide semiconductor layer 13 may be immersed in a solution containing a photosensitizing dye and a co-adsorbent. At this time, the immersion time for the oxide semiconductor layer 13 in the solution is preferably 10 hours to 48 hours, and more preferably 15 hours to 25 hours.

Next, an electrolyte 40 is disposed on the oxide semiconductor layer 13. The electrolyte 40 can be disposed by, for example, a printing method such as screen printing.

Next, a sealing section-forming body for forming a sealing section 30 is prepared. The sealing section-forming body is obtained by preparing a resin film for sealing, and forming one rectangular-shaped opening in that resin film for sealing.

Then, this sealing section-forming body is adhered to the working electrode 10. The adhesion of the sealing section-forming body to the working electrode 10 can be carried out by heating and melting the sealing section-forming body.

Next, a counter electrode 20 is prepared and bonded to the sealing section-forming body so as to block the opening thereof, and thus a sealing section 30 is formed between the working electrode 10 and the counter electrode 20. The bonding of the counter electrode 20 to the sealing section-forming body may be carried out at atmospheric pressure or may be carried out under reduced pressure, but it is preferable to carry out the bonding under reduced pressure. Meanwhile, at this time, the sealing section 30 may also be formed between the working electrode 10 and the counter electrode 20 by adhering the sealing section-forming body in advance to the counter electrode 20 as well, and bonding the sealing section-forming bodies.

In the manner described above, the dye-sensitized solar cell 100 for low illumination is obtained.

The present invention is not intended to be limited to the embodiments described above. For example, in the embodiments described above, the oxide semiconductor layer 13 is provided on the transparent conductive film 12 of the transparent conductive substrate 15, but the oxide semiconductor layer 13 may also be provided on the counter electrode 20.

Furthermore, in the embodiments described above, the counter electrode 20 is composed of a conductive substrate 21 and a catalyst layer 22, but the counter electrode 20 may also be composed of a transparent substrate 11 and a transparent conductive film 12 that is provided thereon, similarly to the working electrode 10.

### EXAMPLES

Hereinafter, the matters of the present invention will be more specifically described by way of Examples, but the present invention is not intended to be limited to the Examples described below.

### (Example 1)

First, a transparent conductive substrate obtained by forming a transparent conductive film having a thickness of 1 µm and formed of FTO, on a transparent substrate having a thickness of 1 mm and formed of glass was prepared. Subsequently, patterning was carried out using a CO₂ laser (V-460 manufactured by Universal Systems, Inc.) such that four transparent conductive films arranged in one row would be formed. Patterning was carried out such that the four transparent conductive films would respectively have a rectangular-shaped main body section having a size of 3 cm × 5 cm, and the distance between the main body sections would be 0.5 mm. Furthermore, in three transparent conductive films among the four transparent conductive films, two protruding sections protruding from each of the two lateral edges of the main body section, and an extension section extending from each of the two protruding sections to a position lateral to the side edge of the main body section of the corresponding transparent conductive film of an adjacent DSC were formed. At this time, the length of the protruding section in the direction of protrusion was adjusted to 1 cm, and the width of the protruding section was adjusted to 3 mm. Furthermore, the width of the extension section was adjusted to 2 mm, and the length of the extension section in the direction of extension was adjusted to 2 cm.

Next, a paste for forming an oxide semiconductor layer containing titania was applied on the main body sections of the transparent conductive film, and the paste was dried and then calcined for one hour at 500°C. Thus, a working electrode having an oxide semiconductor layer was obtained.

Next, a paste containing a low melting point glass was applied by screen printing in the regions between the main body sections, and then the paste was calcined. Thus, an insulating material formed of a low melting point glass was formed in the regions between adjoining main body sections.

Next, the working electrode was immersed for one whole day and night in a dye solution which contained 0.3 mmol of a photosensitized dye composed of N719 and 3 mmol of a co-adsorbent composed of deoxycholic acid (DCA), and contained a mixed solvent prepared by mixing acetonitrile and tert-butanol at a volume ratio of 1:1 as the solvent. Subsequently, the working electrode was removed and dried, and thus the photosensitized dye was supported on the oxide semiconductor layer, and simultaneously the co-adsorbent was also adsorbed thereon.

Next, an electrolyte containing iodine redox couples was applied on the oxide semiconductor layer and dried, and thereby, an electrolyte was disposed. At this time, the I₃⁻ concentration in the electrolyte was set to 3×10⁻⁶ mol/liter.

Next, a first sealing section-forming body for forming a first sealing section was prepared. The first sealing section-forming body was obtained by preparing one sheet of a resin film for sealing formed from an ethylene-methacrylic acid copolymer (trade name: NUCREL, manufactured by Mitsui DuPont Polychemical Co., Ltd.) and having a size of 12 cm × 5 cm × 50 µm, and forming four rectangular-shaped openings in the resin film for sealing. At this time, the first sealing section-forming body was produced such that each of the openings would have a size of 2.8 cm × 4.8 cm × 50 µm, and the width would be 1 mm.

This first sealing section-forming body was mounted on the working electrode, and then was adhered to the working electrode by heating and melting the first sealing section-forming body.

Next, four sheets of counter electrodes were prepared. Each of the counter electrodes was prepared by forming by a sputtering method a catalyst layer formed of platinum and having a thickness of 10 nm on a titanium foil having a size of 2.95 cm × 5 cm × 40 µm. Furthermore, another first sealing section-forming body was prepared, and this first sealing section-forming body was adhered as in the same manner as the above to the surface of the counter electrode which faces the working electrode.

The first sealing section-forming body adhered to the working electrode and the first sealing section-forming body adhered to the counter electrode were arranged to face each other, and the first sealing section-forming bodies were superimposed. In this state, the first sealing section-forming bodies were heated and melted while the first sealing section-forming bodies were pressed. Thus, the first sealing section was formed between the working electrode and the counter electrode.

Next, a second sealing section was prepared. The second sealing section was obtained by preparing one sheet of a resin film for sealing formed of a maleic anhydride-modified polyethylene (trade name: BYNEL, manufactured by DuPont Company) and having a size of 13 cm × 6 cm × 50 µm, and forming four rectangular-shaped openings in the resin film for sealing. At this time, the second sealing section was produced such that each of the openings would have a size of 2.8 cm × 4.8 cm × 50 µm, the width of the outer peripheral section would be 1.5 mm, and the width of the partition section that partitioned the openings on the inner side of the outer peripheral section would be 1 mm. The second sealing section was bonded to the counter electrode such that the second sealing section, together with the first sealing section, sandwiched the edges of the counter electrode. At this time, the second sealing section was bonded to the counter electrode and the first sealing section by heating and melting the first sealing section and the second sealing section while pressing the second sealing section against the counter electrode.

Finally, a low temperature-curable type silver paste (manufactured by Fujikura Kasei Co., Ltd., D-500) was prepared and applied over a region extending from the counter electrode to the extension sections of the corresponding transparent conductive film of an adjoining DSC, and the silver paste was cured for 12 hours at 30°C. In this manner, an electroconductive material that was formed of silver and connected the counter electrode with the extension sections of the corresponding transparent conductive film of an adjoining DSC, was formed. The dimension of the electroconductive material was 7 mm × 10 mm × 10 µm. In this manner, a DSC module was obtained.

### (Examples 2 to 22 and Comparative Examples 1 to 6)

DSC modules were produced in the same manner as in Example 1, except that the concentrations (unit: µM) of the photosensitizing dye, co-adsorbent 1, co-adsorbent 2 and I₃⁻ were changed as indicated in Table 1 and-Table 2.

### (Examples 23 and 24)

DSC modules were produced in the same manner as in Example 1, except that the concentrations (unit: µM) of the photosensitizing dye, co-adsorbent 1, co-adsorbent 2 and I₃⁻ were changed as indicated in Table 2. At this time, the molar ratio of the co-adsorbent 2 with respect to the co-adsorbent 1 was adjusted to 3.

As shown in Table 1 and Table 2, the open circuit voltage Voc at 100 Lux and the photoelectric conversion efficiency η were measured for the DSC modules obtained in Examples 1 to 24 and Comparative Examples 1 to 6. Here, the photoelectric conversion efficiency η was measured respectively in the cases where the illumination intensity was adjusted to 10 Lux, 100 Lux, 1000 Lux, 1000 Lux, and 20000 Lux. The results are presented in Table 1 and Table 2.

As shown in Table 1 and Table 2, in the DSC modules obtained in Examples 1 to 24, the open circuit voltage at an illumination intensity of 100 Lux (the measurement light source was a fluorescent lamp) tended to be higher as compared with the DSC modules obtained in Comparative Examples 1 to 6.

Furthermore, in the DSC modules obtained in Examples 1 to 24, the photoelectric conversion efficiency values at illumination intensities of 10,000 Lux or less (the measurement light source was a fluorescent lamp) were all greater than the photoelectric conversion efficiency values at illumination intensities that did not fall in the range of illumination intensity described above (20,000 Lux). On the contrary, in the DSC modules obtained in Comparative Examples 1 to 6, there were occasions in which the photoelectric conversion efficiency values at illumination intensities of 10,000 Lux or less were almost the same as the photoelectric conversion efficiency values at illumination intensities that did not fall in the range of illumination intensity described above.

From the above results, it was confirmed that the DSC for low illumination of the present invention has excellent photoelectric conversion characteristics in an environment at low illumination.

**[TABLE 1]**

| | Photosensitizing dye | Co-adsorbent 1 | Co-adsorbent 2 | Concentration of I₃⁻ (µM) | Open circuit voltage Voc at 100 Lux (mV) | Photoelectric conversion efficiency (%) | | | | |
|---|---|---|---|---|---|---|---|---|---|---|
| | | | | | | 10 Lux | 100 Lux | 1000 Lux | 10000 Lux | 20000 Lux |
| Example 1* | N719 | A | - | 3 | 600 | 7.2 | 12.5 | 16.1 | 9.5 | 4.5 |
| Example 2* | N719 | B | - | 3 | 590 | 7 | 11.9 | 15.4 | 8.9 | 4.3 |
| Example 3* | N719 | C | - | 3 | 590 | 7.1 | 11.9 | 15.6 | 9.1 | 4 |
| Example4* | N719 | D | - | 3 | 570 | 6.8 | 11.7 | 15.3 | 9.2 | 4.1 |
| Example 5* | N719 | E | - | 3 | 570 | 6.8 | 11.5 | 15.4 | 9.1 | 4 |
| Example 6* | N719 | F | - | 3 | 560 | 6.6 | 11.9 | 15.2 | 8.8 | 4.2 |
| Example 7* | N719 | G | - | 3 | 560 | 6.6 | 12.1 | 15.3 | 8.9 | 4.3 |
| Example 8* | N719 | H | - | 3 | 540 | 6.3 | 10.5 | 15 | 8.9 | 4.2 |
| Example 9* | N3 | A | - | 3 | 560 | 6.1 | 11 | 14 | 9.1 | 4.2 |
| Example 10* | N3 | B | - | 3 | 560 | 6 | 10.9 | 14.1 | 9.1 | 4.1 |
| Example 11* | N3 | C | - | 3 | 550 | 5.9 | 10.5 | 13.8 | 9 | 3.9 |
| Example 12* | N3 | D | - | 3 | 540 | 5.9 | 10.5 | 14 | 9.1 | 3.8 |
| Example 13* | N3 | E | - | 3 | 540 | 5.5 | 10.4 | 13.9 | 9 | 3.8 |
| Example 14* | N3 | F | - | 3 | 550 | 5.7 | 10.4 | 13.6 | 9 | 3.9 |
| Example 15* | N3 | G | - | 3 | 540 | 5.6 | 10.2 | 13.7 | 8.9 | 3.9 |
| Example 16* | N3 | H | - | 3 | 530 | 5.5 | 10.3 | 13.5 | 8.9 | 3.8 |

**[TABLE 2]**

| | Photosensitizing dye | Co-adsorbent 1 | Co-adsorbent 2 | Concentration of I₃⁻ (µM) | Open circuit voltage Voc at 100 Lux (mV) | Photoelectric conversion efficiency (%) | | | | |
|---|---|---|---|---|---|---|---|---|---|---|
| | | | | | | 10 Lux | 100 Lux | 1000 Lux | 10000 Lux | 20000 Lux |
| Example 17* | N719 | K | - | 3 | 590 | 7.1 | 11.8 | 16 | 9.2 | 4.1 |
| Example 18* | N719 | L | - | 3 | 580 | 6.9 | 11.6 | 15.6 | 9.3 | 4.3 |
| Example 19* | N719 | M | - | 3 | 590 | 6.9 | 12 | 15.6 | 9 | 4.6 |
| Example 20* | N719 | N | - | 3 | 560 | 7 | 11.6 | 15.3 | 9.1 | 4.2 |
| Example 21* | N719 | O | - | 3 | 560 | 6.5 | 12.1 | 15.2 | 9.1 | 3.8 |
| Example 22* | N719 | A | - | 500 | 530 | 6 | 10.1 | 14.1 | 9.2 | 4.9 |
| Example 23 | N719 | A | P | 3 | 610 | 7.4 | 12.9 | 16.5 | 9.5 | 4.5 |
| Example 24 | N719 | A | Q | 3 | 620 | 7.8 | 13.1 | 16.6 | 9.5 | 4.4 |
| Comparative Example 1 | N719 | - | - | 3 | 520 | 4.8 | 9.9 | 13.1 | 8.7 | 4.9 |
| Comparative Example 2 | N3 | - | - | 3 | 490 | 3.9 | 9.1 | 12.6 | 8.4 | 4.6 |
| Comparative Example 3 | N719 | I | - | 3 | 530 | 4.6 | 9:7 | 13 | 8.7 | 4 |
| Comparative Example 4 | N3 | J | - | 3 | 500 | 3.8 | 9 | 12.6 | 8.4 | 3.7 |
| Comparative Example 5 | Z907 | A | - | 3 | 500 | 4.9 | 9.8 | 12.9 | 8.7 | 4.5 |
| Comparative Example 6 | Black dye | A | - | 3 | 480 | 3.7 | 8.9 | 11.2 | 8.1 | 4 |

| | | | | | | | | | | |
|---|---|---|---|---|---|---|---|---|---|---|
| * Reference Example | | | | | | | | | | |

A to Q in Table 1 and Table 2 represent the following compounds. Meanwhile, the values within the parentheses of A to H, P and Q each represent the distance between the oxygen atom (O) of an OH group in the organic compound represented by any one of formulas (2) to (4) and formula (X) and the atom that is at the farthest position from that oxygen atom (O).
A: Deoxycholic acid (DCA, 1.5 nm)
B: Kenodeoxycholic acid (1.5 nm)
C: Cholic acid (1.5 nm)
D: 4-Guanidinobutanoic acid (1 nm)
E: 3-Phenylpropionic acid (0.9 nm)
F: 2,3-Pyridinedicarboxylic acid (0.9 nm)
G: 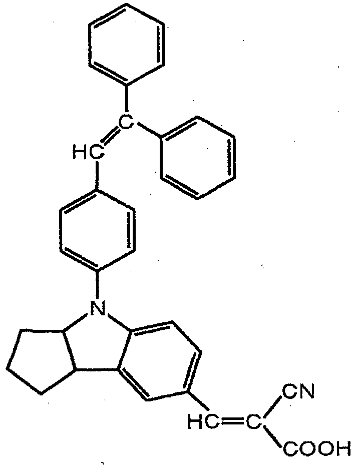 (1.7 nm)
H: 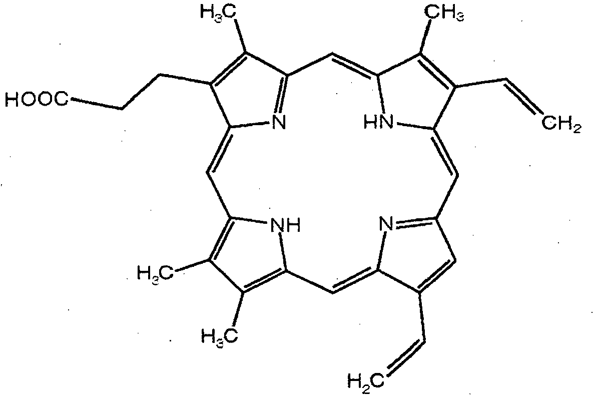 (1.7 nm)
I: Dodecanoic acid
J: Malic acid
K: 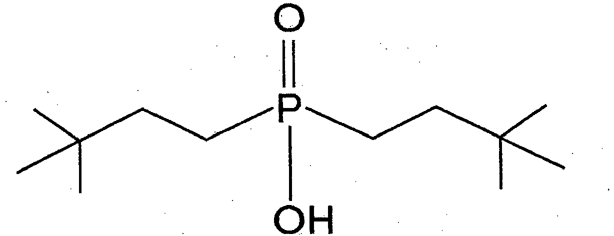 Bis(3,3-dimethylbutyl)phosphinic acid (DINHOP)
L: 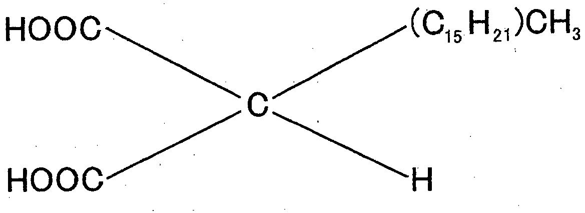 2-Hexadecylmalonic acid (HDMA)
M: 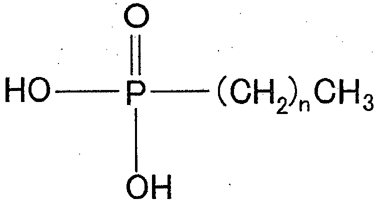 n-Decylphosphonic acid (DPA)
N: 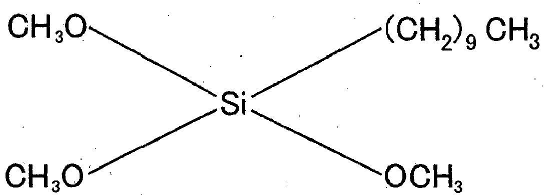 Decyltrimethoxysilane
O: 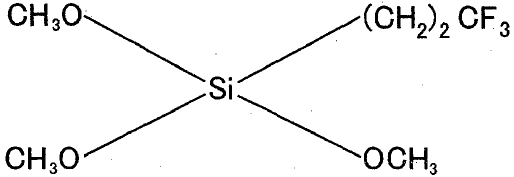 Trifluoropropyltrimethoxysilane
P: 5-Tert-butyl-2-pyridinecarboxylic acid (0.8 nm)
Q: t-Butyl alcohol (0.4 nm)

### EXPLANATIONS OF REFERRENCE NUMERALS

- 10: Working electrode
- 11: Transparent substrate
- 12: Transparent conductive film
- 13: Oxide semiconductor layer
- 15: Transparent conductive substrate (first electrode)
- 20: Counter electrode (second electrode)
- 100: Dye-sensitized solar cell

## Claims

1. A dye-sensitized solar cell for low illumination, comprising:
a first electrode comprising a transparent substrate and a transparent conductive film provided on the transparent substrate;
a second electrode that faces the first electrode;
an oxide semiconductor layer that is provided on the first electrode or the second electrode;
an electrolyte that is provided between the first electrode and the second electrode;
a photosensitizing dye that is adsorbed to the oxide semiconductor layer; and
a co-adsorbent that is adsorbed to the oxide semiconductor layer together with the photosensitizing dye,
the photosensitizing dye being a metal complex compound represented by the following formula (1),
**characterized in that**
the co-adsorbent comprising two kinds of organic compounds selected from the group consisting of an organic compound represented by the following formula (2), an organic compound represented by the following formula (3), and an organic compound represented by the following formula (4) or comprising an organic compound selected from the organic compounds represented by formulas (2) to (4) and an organic compound represented by the following formula (X):: 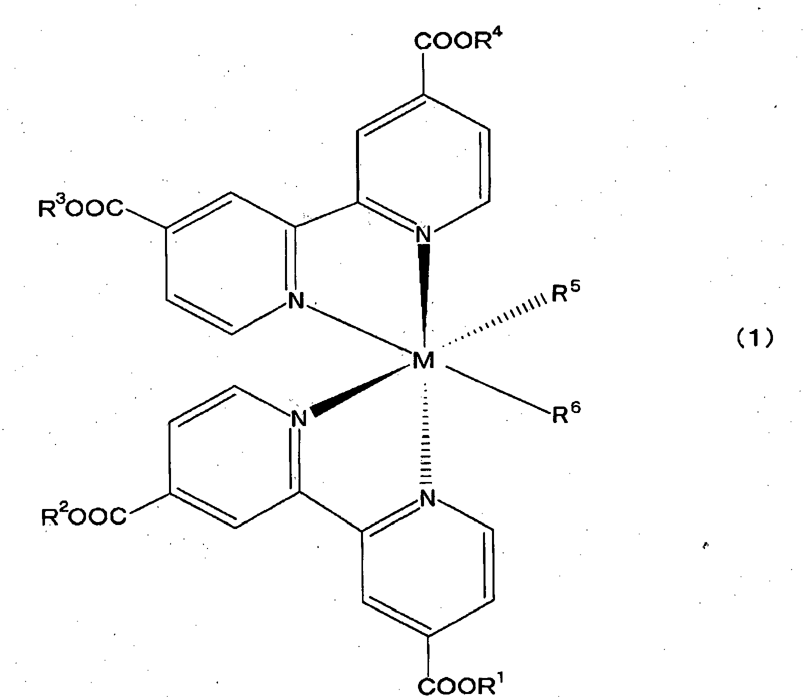 wherein in formula (1), M represents Ru; R¹, R², R³, and R⁴ each independently represent a monovalent cation; and R⁵ and R⁶ each independently represent a halogen group, -H, - CN, -NCS, or -NCO; 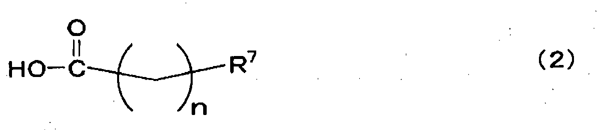 wherein in formula (2), n represents an integer from 0 to 5; and R⁷ represents a monovalent group having a π-conjugated structure, or a monovalent group having a steroid skeleton; 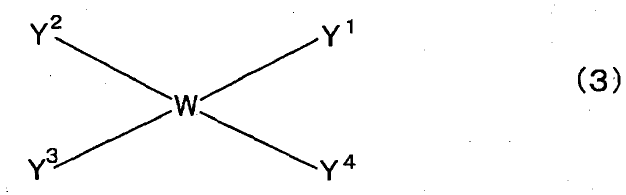 wherein in formula (3), W represents a carbon atom or a silicon atom; Y¹, Y², Y³, and Y⁴ each independently represent a hydrogen atom, a carboxyl group, a substituted or unsubstituted alkoxy group having 1 to 6 carbon atoms, or a substituted or unsubstituted hydrocarbon group having 3 to 20 carbon atoms; and one of Y¹, Y², Y³, and Y⁴ represents a substituted or unsubstituted hydrocarbon group having 3 to 20 carbon atoms, while at least two of the remaining groups each represent a carboxyl group or a substituted or unsubstituted alkoxy group having 1 to 6 carbon atoms; 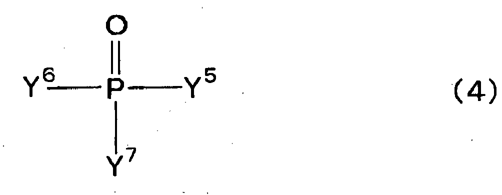 wherein in formula (4), Y⁵, Y⁶, and Y⁷ each independently represent a hydroxyl group or a substituted or unsubstituted hydrocarbon group having 3 to 20 carbon atoms; and one or two of Y⁵, Y⁶, and Y⁷ each represent a substituted or unsubstituted hydrocarbon group having 3 to 20 carbon atoms, while the others represent hydroxyl groups; and 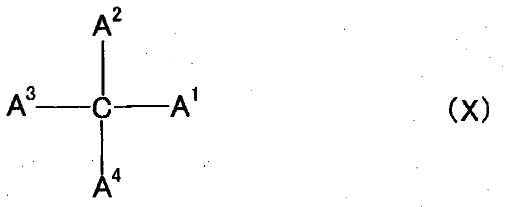 wherein in formula (X), A¹ to A³ each independently represent a hydrogen atom or a methyl group; and A⁴ represents a hydroxyl group or a carboxyl group.

2. The dye-sensitized solar cell according to claim 1, wherein the monovalent group having a π-conjugated structure in R⁷ in the formula (2) is a monovalent group having a merocyanine skeleton represented by the formula (7), a phenyl skeleton, a guanidine skeleton, a pyridine skeleton, or a porphyrin skeleton, and
the monovalent group having a steroid skeleton is a monovalent group represented by the following formula (5): 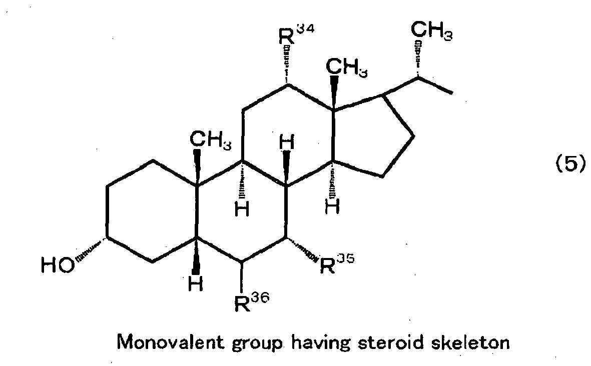 wherein in formula (5), R³⁴, R³⁵, and R³⁶ each independently represent a hydrogen atom or a hydroxyl group, 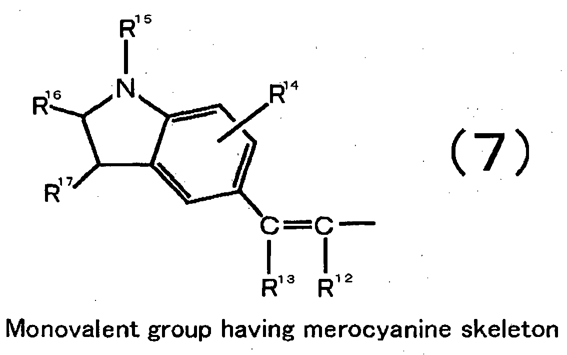 wherein in formula (7), R¹² represents a hydrogen atom, -CN, or a hydrocarbon group having 1 to 5 carbon atoms; R¹³, R¹⁴, R¹⁶ and R¹⁷ each represent a hydrogen atom or a hydrocarbon group having 1 to 5 carbon atoms; and R¹⁵ represents a phenyl group substituted with an alkoxy group having 1 to 5 carbon atoms, or is represented by the following formula (8), R¹⁶ and R¹⁷ may be bonded to each other and form a 5-membered ring or a 6-memebred ring, 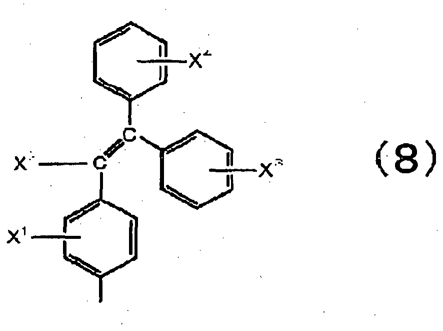 wherein in formula (8), X¹, X², X³ and X⁴ each independently represent a hydrogen atom or a hydrocarbon group having 1 to 5 carbon atoms.

3. The dye-sensitized solar cell according to claim 2, wherein the monovalent group having a π-conjugated structure in R⁷ in the formula (2) is a monovalent group having the merocyanine skeleton or a guanidine skeleton.

4. The dye-sensitized solar cell according to any one of claims 1 to 3, wherein in formula (1), at least one of R¹, R², R³, and R⁴ is a hydrogen ion.

5. The dye-sensitized solar cell according to any one of claims 1 to 3, wherein in formula (1), at least one of R¹, R², R³, and R⁴ is a hydrogen ion, and the others are each a monovalent ammonium salt.

6. The dye-sensitized solar cell according to claim 4 or 5, wherein in formula (1), R⁵ and R⁶ are each -NCS.

7. The dye-sensitized solar cell according to any one of claims 1 to 6, wherein the molar ratio of the co-adsorbent with respect to the photosensitizing dye is 0.1 to 1.

## Patentansprüche

1. Farbstoffsensibilisierte Solarzelle für niedrige Beleuchtung, umfassend:
eine erste Elektrode, umfassend ein transparentes Substrat und einen transparenten leitenden Film, der auf dem transparenten Substrat vorgesehen ist,
eine zweite Elektrode, die der ersten Elektrode gegenüberliegt,
eine Oxid-Halbleiterschicht, die auf der ersten Elektrode oder der zweiten Elektrode vorgesehen ist,
einen Elektrolyten, der zwischen der ersten und der zweiten Elektrode vorgesehen ist,
einen lichtsensibilisierenden Farbstoff, der an die Oxid-Halbleiterschicht adsorbiert ist, und
ein Coadsorptionsmittel, das an die Oxid-Halbleiterschicht zusammen mit dem lichtsensibilisierenden Farbstoff adsorbiert ist,
worin der lichtsensibilisierende Farbstoff eine Metallkomplexverbindung mit der folgenden Formel (1) ist,
**dadurch gekennzeichnet, dass**
das Coadsorbens zwei Arten von organischen Verbindungen enthält, ausgewählt aus der Gruppe bestehend aus einer organischen Verbindung, dargestellt durch die folgende Formel (2), einer organischen Verbindung, dargestellt durch die folgende Formel (3), und einer organischen Verbindung, dargestellt durch die folgende Formel (4), oder umfassend eine organische Verbindung, ausgewählt aus den organischen Verbindungen, dargestellt durch die Formeln (2) bis (4) und einer organischen Verbindung, dargestellt durch die folgende Formel (X) : 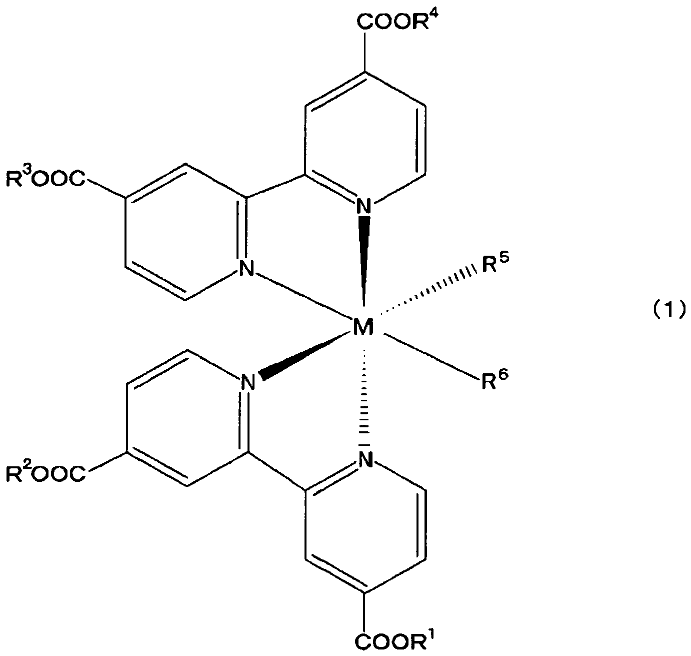 worin in der Formel (1) M Ru ist, R¹, R², R³ und R⁴ jeweils unabhängig ein monovalentes Kation sind und R⁵ und R⁶ jeweils unabhängig eine Halogengruppe, -H, -CN, -NCS oder -NCO sind, 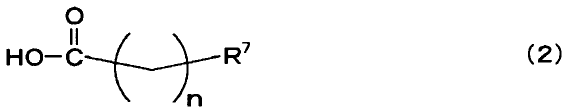 worin in der Formel (2) n eine ganze Zahl von 0 bis 5 ist und R⁷ eine monovalente Gruppe mit einer n-konjugierten Struktur oder eine monovalente Gruppe mit einem Steroidgerüst ist, 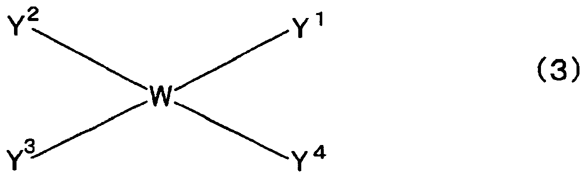 worin in der Formel (3) W ein Kohlenstoffatom oder Siliziumatom ist, Y¹, Y², Y³ und Y⁴ jeweils unabhängig ein Wasserstoffatom, eine Carboxylgruppe, substituierte oder unsubstituierte Alkoxygruppe mit 1 bis 6 Kohlenstoffatomen oder substituierte oder unsubstituierte Kohlenwasserstoffgruppe mit 3 bis 20 Kohlenstoffatomen sind; und eines von Y¹, Y², Y³ und Y⁴ eine substituierte oder unsubstituierte Kohlenwasserstoffgruppe mit 3 bis 20 Kohlenstoffatomen ist, während zumindest zwei der verbleibenden Gruppen jeweils eine Carboxylgruppe oder substituierte oder unsubstituierte Alkoxygruppe mit 1 bis 6 Kohlenstoffatomen sind, 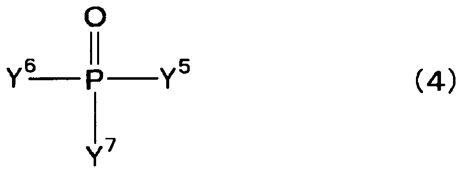 worin in der Formel (4) Y⁵, Y⁶ und Y⁷ jeweils unabhängig eine Hydroxylgruppe oder substituierte oder unsubstituierte Kohlenwasserstoffgruppe mit 3 bis 20 Kohlenstoffatomen sind und eines oder zwei von Y⁵, Y⁶ und Y⁷ jeweils eine substituierte oder unsubstituierte Kohlenwasserstoffgruppe mit 3 bis 20 Kohlenstoffatomen sind, während die anderen Hydroxylgruppen sind, und 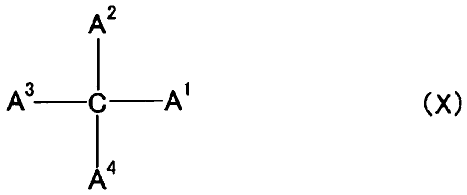 worin in der Formel (X) A¹ bis A³ jeweils unabhängig ein Wasserstoffatom oder eine Methylgruppe sind und A⁴ eine Hydroxylgruppe oder Carboxylgruppe ist.

2. Farbstoffsensibilisierte Solarzelle nach Anspruch 1, worin die monovalente Gruppe mit einer π-konjugierten Struktur in R⁷ in der Formel (2) eine monovalente Gruppe mit einem Merocyaningerüst, dargestellt durch die Formel (7), Phenylgerüst, Guanidingerüst, Pyridingerüst oder Porphyringerüst und
die monovalente Gruppe mit einem Steroidgerüst eine monovalente Gruppe ist, dargestellt durch die folgende Formel (5): 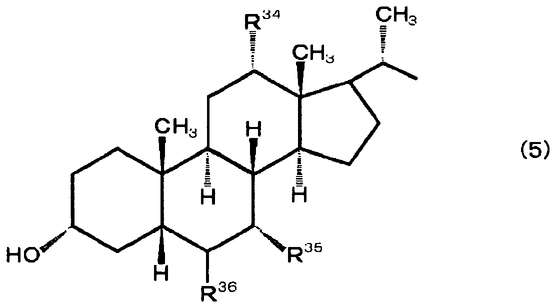 Monovalente Gruppe mit Steroidgerüst
worin in der Formel (5) R³⁴, R³⁵ und R³⁶ jeweils unabhängig ein Wasserstoffatom oder eine Hydroxylgruppe sind, 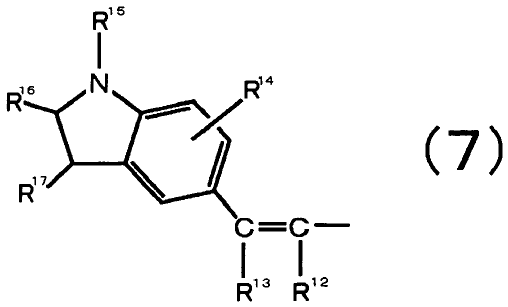 Monovalente Gruppe mit Merocyaningerüst
worin in der Formel (7) R¹² ein Wasserstoffatom, -CN oder eine Kohlenwasserstoffgruppe mit 1 bis 5 Kohlenstoffatomen ist, R¹³, R¹⁴, R¹⁶ und R¹⁷ jeweils ein Wasserstoffatom oder eine Kohlenwasserstoffgruppe mit 1 bis 5 Kohlenstoffatomen sind und R¹⁵ eine Phenylgruppe ist, substituiert mit einer Alkoxygruppe mit 1 bis 5 Kohlenstoffatomen oder durch die folgende Formel (8) dargestellt ist, R¹⁶ und R¹⁷ aneinander gebunden sein können und einen 5- oder 6-gliedrigen Ring bilden können, 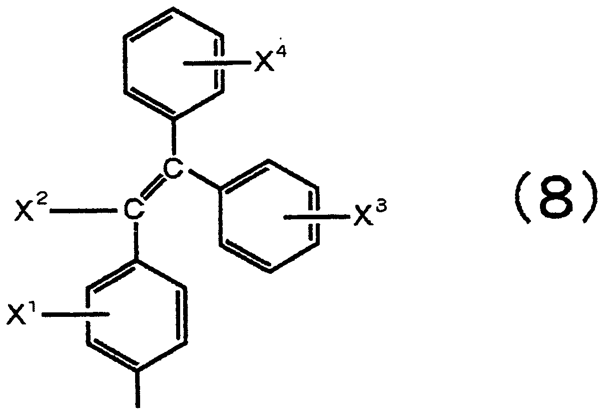 worin in der Formel (8) X¹, X², X³ und X⁴ jeweils unabhängig ein Wasserstoffatom oder eine Kohlenwasserstoffgruppe mit 1 bis 5 Kohlenstoffatomen sind.

3. Farbstoffsensibilisierte Solarzelle nach Anspruch 2, worin die monovalente Gruppe mit einer π-konjugierten Struktur in R⁷ in der Formel (2) eine monovalente Gruppe mit dem Merocyaningerüst oder einem Guanidingerüst ist.

4. Farbstoffsensibilisierte Solarzelle nach einem der Ansprüche 1 bis 3, worin in der Formel (1) zumindest eines von R¹, R², R³ und R⁴ ein Wasserstoffion ist.

5. Farbstoffsensibilisierte Solarzelle nach einem der Ansprüche 1 bis 3, worin in der Formel (1) zumindest eines von R¹, R², R³ und R⁴ ein Wasserstoffion ist und die anderen jeweils ein monovalentes Ammoniumsalz sind.

6. Farbstoffsensibilisierte Solarzelle nach Anspruch 4 oder 5, worin in der Formel (1) R⁵ und R⁶ jeweils -NCS sind.

7. Farbstoffsensibilisierte Solarzelle nach einem der Ansprüche 1 bis 6, worin das molare Verhältnis des Coadsorbens in Bezug auf den lichtsensibilisierenden Farbstoff 0,1 bis 1 ist.

## Revendications

1. Cellule photovoltaïque sensibilisée par un colorant pour éclairage faible, comprenant :
une première électrode comprenant un substrat transparent et un film transparent conducteur prévu sur le substrat transparent ;
une deuxième électrode qui fait face à la première électrode ;
une couche semi-conductrice d'oxyde qui est prévue sur la première électrode ou la deuxième électrode ;
un électrolyte qui est prévu entre la première électrode et la deuxième électrode ;
un colorant de photosensibilisation qui est adsorbé sur la couche semi-conductrice d'oxyde ; et
un co-adsorbant qui est adsorbé sur la couche semi-conductrice d'oxyde en même temps que le colorant de photosensibilisation,
le colorant de photosensibilisation étant un composé complexe métallique représenté par la formule (1) suivante,
**caractérisée en ce que**
le co-adsorbant comprend deux types de composés organiques choisis parmi le groupe consistant en un composé organique représenté par la formule (2) suivante, un composé organique représenté par la formule (3) suivante, et un composé organique représenté par la formule (4) suivante ou comprenant un composé organique choisi parmi les composés organiques représentés par les formules (2) à (4) et un composé organique représenté par la formule (X) suivante 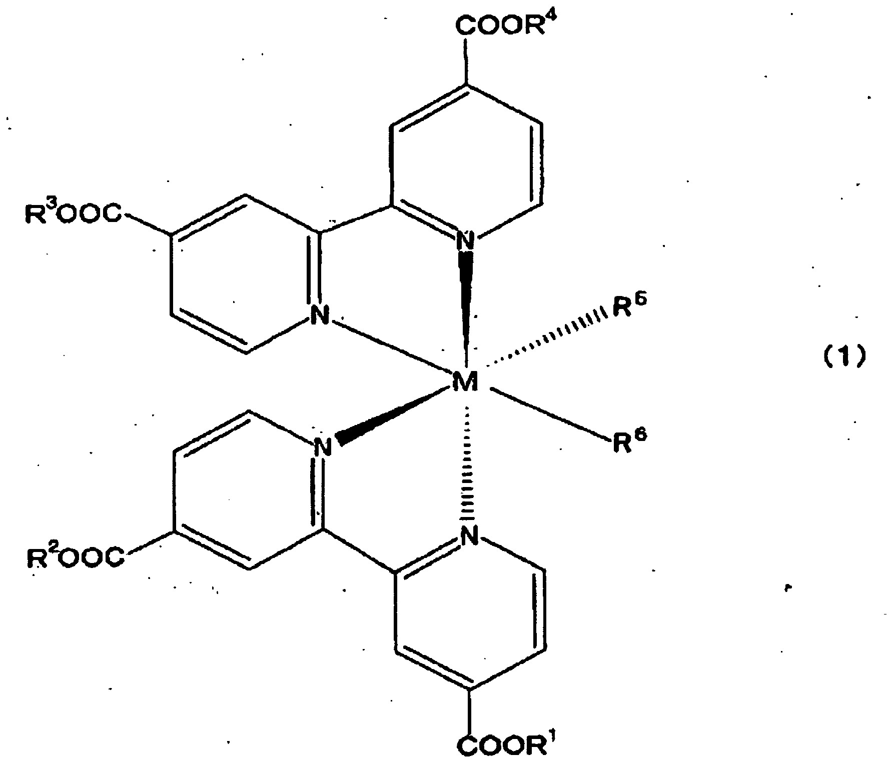 dans laquelle, dans la formule (1), M représente Ru ; R¹, R², R³, et R⁴ représentent chacun indépendamment un cation monovalent ; et R⁵ et R⁶ représentent chacun indépendamment un groupe halogène, -H, -CN, -NCS, ou -NCO ; 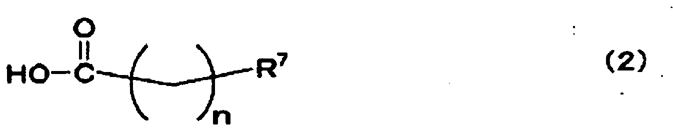 dans laquelle, dans la formule (2), n représente un entier de 0 à 5 ; et R⁷ représente un groupe monovalent ayant une structure conjuguée à liaison n, ou un groupe monovalent ayant un squelette stéroïde ; 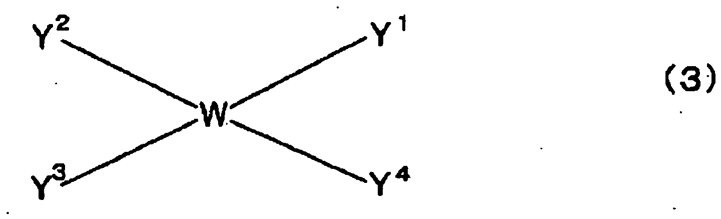 dans laquelle, dans la formule (3), W représente un atome de carbone ou un atome de silicium ; Y¹, Y², Y³, et Y⁴ représentent chacun indépendamment un atome d'hydrogène, un groupe carboxyle, un groupe alcoxy substitué ou non substitué ayant 1 à 6 atomes de carbone, ou un groupe hydrocarboné substitué ou non substitué ayant 3 à 20 atomes de carbone ; et un parmi Y¹, Y², Y³, et Y⁴ représente un groupe hydrocarboné substitué ou non substitué ayant 3 à 20 atomes de carbone, tandis qu'au moins deux des groupes restants représentent chacun un groupe carboxyle ou un groupe alcoxy substitué ou non substitué ayant 1 à 6 atomes de carbone ; 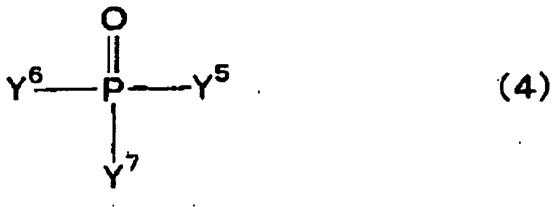 dans laquelle, dans la formule (4), Y⁵, Y⁶, et Y⁷ représentent chacun indépendamment un groupe hydroxyle ou un groupe hydrocarboné substitué ou non substitué ayant 3 à 20 atomes de carbone ; et un ou deux parmi Y⁵, Y⁶, et Y⁷ représente(nt) chacun un groupe hydrocarboné substitué ou non substitué ayant 3 à 20 atomes de carbone, tandis que les autres représentent des groupes hydroxyle ; et 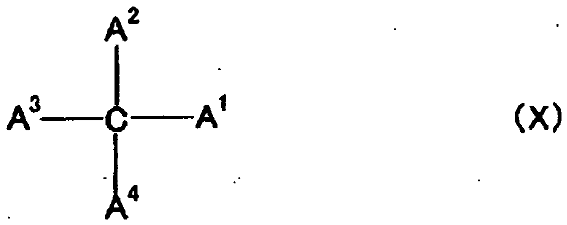 dans laquelle, dans la formule (X), A¹ à A³ représentent chacun indépendamment un atome d'hydrogène ou un groupe méthyle ; et A⁴ représente un groupe hydroxyle ou un groupe carboxyle.

2. Cellule photovoltaïque sensibilisée par un colorant selon la revendication 1, dans laquelle le groupe monovalent ayant une structure conjuguée à liaison n dans R⁷ dans la formule (2) est un groupe monovalent ayant un squelette mérocyanine représenté par la formule (7), un squelette phényle, un squelette guanidine, un squelette pyridine, ou un squelette porphyrine, et
le groupe monovalent ayant un squelette stéroïde est un groupe monovalent représenté par la formule (5) suivante : 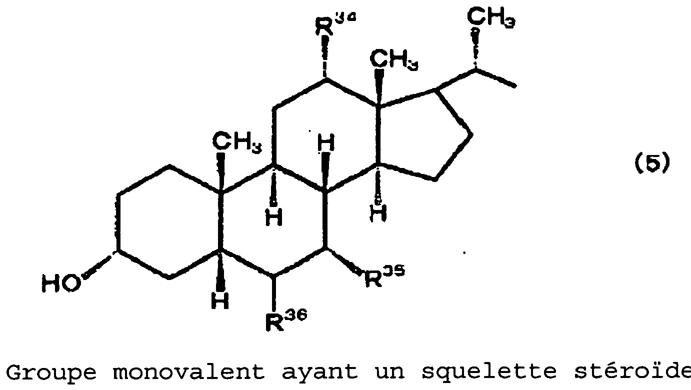 dans laquelle, dans la formule (5), R³⁴, R³⁵, et R³⁶ représentent chacun indépendamment un atome d'hydrogène ou un groupe hydroxyle, 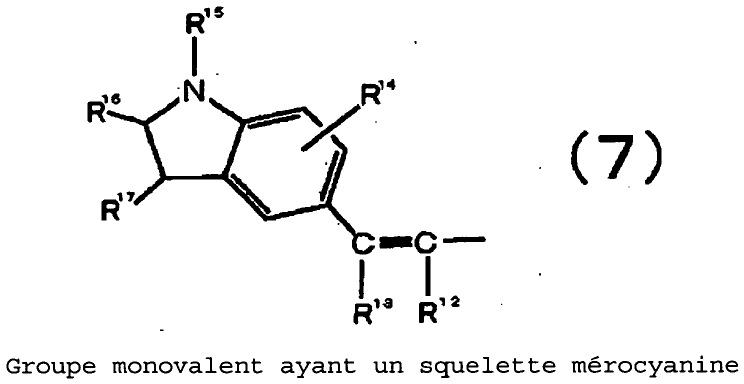 dans laquelle, dans la formule (7), R¹² représente un atome d'hydrogène, -CN, ou un groupe hydrocarboné ayant 1 à 5 atomes de carbone ; R¹³, R¹⁴, R¹⁶, et R¹⁷ représentent chacun un atome d'hydrogène ou un groupe hydrocarboné ayant 1 à 5 atomes de carbone ; et R¹⁵ représente un groupe phényle substitué avec un groupe alcoxy ayant 1 à 5 atomes de carbone, ou est représenté par la formule (8) suivante, R¹⁶ et R¹⁷ peuvent être liés l'un à l'autre et former un cycle à 5 éléments ou un cycle à 6 éléments, 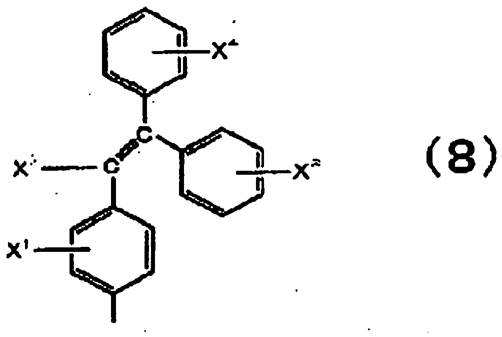 dans laquelle, dans la formule (8), X¹, X², X³ et X⁴ représentent chacun indépendamment un atome d'hydrogène ou un groupe hydrocarboné ayant 1 à 5 atomes de carbone.

3. Cellule photovoltaïque sensibilisée par un colorant selon la revendication 2, dans laquelle le groupe monovalent ayant une structure conjuguée à liaison n dans R⁷ dans la formule (2) est un groupe monovalent ayant le squelette mérocyanine ou un squelette guanidine.

4. Cellule photovoltaïque sensibilisée par un colorant selon l'une quelconque des revendications 1 à 3, dans laquelle, dans la formule (1), au moins un parmi R¹, R², R³, et R⁴ est un ion hydrogène.

5. Cellule photovoltaïque sensibilisée par un colorant selon l'une quelconque des revendications 1 à 3, dans laquelle, dans la formule (1), au moins un parmi R¹, R², R³, et R⁴ est un ion hydrogène, et les autres sont chacun un sel d'ammonium monovalent.

6. Cellule photovoltaïque sensibilisée par un colorant selon la revendication 4 ou 5, dans laquelle, dans la formule (1), R⁵ et R⁶ sont chacun -NCS.

7. Cellule photovoltaïque sensibilisée par un colorant selon l'une quelconque des revendications 1 à 6, dans laquelle le rapport molaire du co-adsorbant par rapport au colorant de photosensibilisation est 0,1 à 1.
